(19) Europäisches Patentamt
European Patent Office
Office européen des brevets

(11) **EP 3 612 421 B1**

(12) **EUROPÄISCHE PATENTSCHRIFT**

(45) Veröffentlichungstag und Bekanntmachung des Hinweises auf die Patenterteilung:
**13.01.2021  Patentblatt 2021/02**

(21) Anmeldenummer: **18715550.2**

(22) Anmeldetag: **22.03.2018**

(51) Int Cl.:
***B60T 17/22*** *(2006.01)*

(86) Internationale Anmeldenummer:
**PCT/EP2018/057365**

(87) Internationale Veröffentlichungsnummer:
**WO 2018/192737 (25.10.2018 Gazette 2018/43)**

(54) **VERFAHREN ZUM EINLERNEN VON SCHALTPARAMETERN EINES MAGNETSTEUERVENTILS IN EINEM BREMSSYSTEM EINES FAHRZEUGES SOWIE BREMSSYSTEM**

METHOD FOR RETRIEVING SWITCHING PARAMETERS OF SOLENOID VALVES IN A BRAKE SYSTEM

METHODE POUR DETERMINER LES PRAMETRES DE COMMUTATION DES SOUPAPES A SOLENOIDE D'UN SYSTEME DE FREINAGE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **20.04.2017  DE 102017003784**

(43) Veröffentlichungstag der Anmeldung:
**26.02.2020  Patentblatt 2020/09**

(73) Patentinhaber: **WABCO GmbH**
**30453 Hannover Niedersachsen (DE)**

(72) Erfinder:
• **DIECKMANN, Thomas**
  **30982 Pattensen (DE)**
• **KÜHNE, Sebastian**
  **31157 Sarstedt (DE)**
• **GOERS, Andreas**
  **30982 Pattensen (DE)**
• **LÜLFING, Ralph-Carsten**
  **30826 Garbsen (DE)**
• **WULF, Oliver**
  **31535 Neustadt (DE)**

(74) Vertreter: **Rabe, Dirk-Heinrich**
  **Wabco GmbH**
  **Am Lindener Hafen 21**
  **30453 Hannover (DE)**

(56) Entgegenhaltungen:
WO-A1-01/92075     WO-A1-2015/074736
DE-A1- 19 510 933   JP-A- H08 104 225
JP-A- S62 173 366

**Beschreibung**

Die Erfindung betrifft ein Verfahren zum Einlernen von Schaltparametern eines Magnetsteuerventils in einem Bremssystem eines Fahrzeuges sowie ein Bremssystem mit Magnetsteuerventilen, das geeignet ist zur Durchführung des Verfahrens.

Betriebsbremssysteme sind als pneumatisch oder hydraulisch arbeitende Systeme bekannt, die über entsprechende Modulatoren auch elektrisch gesteuert einen bestimmten Bremsdruck an Bremszylinder von Betriebsbremsen aussteuern können. Dazu sind in dem vor dem jeweiligen Bremszylinder der jeweiligen Betriebsbremse angeordneten Modulator Magnetsteuerventile vorgesehen, über die in Abhängigkeit eines Steuersignals ein Bremsdruck in dem jeweiligen Bremszylinder aufgebaut werden kann. Über ein als Magnetsteuerventil ausgebildetes Einlassventil kann dazu ein Vorratsdruck aus einem Druckmittelvorrat in den Bremszylinder eingelassen werden, um den Bremsdruck zu erhöhen, oder der Bremszylinder kann über ein als Magnetsteuerventil ausgebildetes Auslassventil entlüftet werden, um den aktuell wirkenden Bremsdruck zu reduzieren. Durch Ansteuern des entsprechenden Magnetsteuerventils über eine bestimmte Pulsdauer kann der Bremsdruck dadurch stufenlos eingestellt werden. Ein derartiges Magnetsteuerventil in einem Modulator ist beispielhaft in DE 10 2014 006 614 A1 beschrieben.

Zum Abstimmen des tatsächlich im Bremszylinder aufgebauten Bremsdruckes im Hinblick auf Herstellungstoleranzen sind mehrere Verfahren bekannt. Zum einen können für jedes Magnetsteuerventil am Bandende Toleranzen erkannt und diese durch eine entsprechende Parametrierung ausgeglichen werden. Dies hat den Nachteil, dass Toleranzen im Bremssystem des Fahrzeuges, in das ein solches Magnetsteuerventil eingebaut ist, beispielsweise durch unterschiedlich ausgebildete Verrohrungen oder Volumina der Bremszylinder, nicht einbezogen werden und diese daher nicht ausgeglichen werden können.

Ist ein Drucksensor an den Modulatoren, in denen die Magnetsteuerventile verbaut sind, vorgesehen, die einen von dem Modulator tatsächlich ausgesteuerten Bremsdruck messen, können die Pulsdauern entsprechend angepasst und dadurch in einem Nachlernvorgang auch Toleranzen im Bremssystem des Fahrzeuges ausgeglichen werden. Ist ein solcher Drucksensor im Modulator allerdings nicht vorhanden, wie z.B. in dem Modulator gemäß DE 10 2014 006 614 A1, kann der Nachlernvorgang nicht durchgeführt werden, da der tatsächlich ausgesteuerte Bremsdruck nicht bekannt ist

Die JPS62173366A offenbart ein System zur Erkennung einer Funktionsstörung des Systems. Bevor das System in Betrieb genommen wird, muss eine Diagnoseschaltung zur Überprüfung der Betriebsbedingungen einer Steuerschaltung für elektromagnetische Ventile bereitgestellt werden. Dabei erzeugt eine Diagnoseschaltung ein Testsignal zum Aktivieren der Schaltelemente mittels einer Steuerschaltung. Gleichzeitig wird der resultierende Zustand der Schaltelemente mit dem Testsignal erfasst, um zu beurteilen, ob es normal oder abnormal ist. Die Impulsbreite des Testsignals wird kürzer gemacht als die eines normalen Ansteuersignals, und der in den Magnetspulen fließende Ansteuerstrom wird so eingestellt, dass er zeitlich nicht den Betriebspegel erreicht.

Auch in weiteren Verfahren findet eine Abstimmung des jeweiligen Magnetsteuerventils während der Fahrt des Fahrzeuges statt. DE 195 10 933 A1 zeigt beispielsweise ein Verfahren zum Bestimmen eines Ansprechdrucks einer Betriebsbremse in einem Bremssystem mit einem Magnetsteuerventil bzw. mit einem Modulator, beispielsweise in einer Anhängerbremsanlage und/oder in einer Motorwagenbremsanlage. Dazu werden gemäß einer Alternative bei unbetätigtem Betriebsbremsventil Testbremsungen mit einem festgelegten Test-Bremsdruck durchgeführt, der durch Ansteuerung des Magnetsteuerventils eingestellt wird. Vor Durchführung der Testbremsung wird eine Fahrzeug-Grund-Beschleunigung erfasst und diese mit einer Fahrzeug-Test-Beschleunigung verglichen, die sich nach Aussteuern des Test-Bremsdruckes ergibt. Ist die Fahrzeug-Test-Beschleunigung gleich der Fahrzeug-Grund-Beschleunigung, hat der Test-Bremsdruck den gesuchten Ansprechdruck der Betriebsbremse nicht überschritten, da sich die Beschleunigung des Fahrzeuges durch die Testbremsung nicht verändert hat. Wird nach schrittweisem Erhöhen des Test-Bremsdruckes die Fahrzeug-Test-Beschleunigung für einen bestimmten Test-Bremsdruck höher als die Fahrzeug-Grund-Beschleunigung, wurde der Ansprechdruck durch den Test-Bremsdruck überschritten.

Somit kann der Ansprechdruck der Betriebsbremse je nach Schrittweite der Erhöhung des Test-Bremsdruckes innerhalb einer bestimmten Toleranz durch die Testbremsungen während der Fahrt des Fahrzeuges ermittelt werden. Gemäß einer weiteren Alternative kann die Testbremsung auch einer normalen Bremsung überlagert werden, wobei die Fahrzeug-Grund-Beschleunigung in dem Fall vor der normalen Bremsung und die Fahrzeug-Test-Beschleunigung nach Beendigung der normalen Bremsung erfasst wird.

Gemäß DE 10 2011 111 862 A1 und EP 1 142 768 A2 ist vorgesehen, anhand von Testbremsungen mit geringem Bremsdruck einen kippkritischen Querbeschleunigungswert eines Fahrzeuges zu ermitteln. Dazu wird ausgewertet, wie sich eine Testbremsung auf eine Drehzahl von kurveninneren Rädern auswirkt, die bei einer Neigung zum Umkippen weniger stark auf den Untergrund drücken. Aus der Drehzahl lässt sich auf eine Radaufstandskraft und darüber der kippkritische Querbeschleunigungswert erfassen.

In WO 01/92075A1 ist ebenfalls beschrieben, einen Ansprechdruck einer Betriebsbremse durch Testbremsungen zu ermitteln, wobei über die Drehzahlen festgestellt wird, ob das Fahrzeug auf die Testbremsung reagiert. Kann bei sukzessiver Erhöhung des Bremsdruckes ab einem bestimmten Zeitpunkt eine Reaktion des Fahrzeuges erfasst werden, wird der zu diesem Zeitpunkt wirkende Bremsdruck als Ansprechdruck der jeweiligen Betriebsbremse festgelegt und im Bremssystem als fester Parameter verwendet.

Nachteilig ist, dass selbst bei Kenntnis des Ansprechdruckes einer Betriebsbremse keine Aussage über die Schaltparameter eines den Betriebsbremsen vorgeschalteten Magnetsteuerventils in den Modulatoren möglich ist. Wird ein derartiges Magnetsteuerventil nachgerüstet oder ausgetauscht oder liegt verschleißbedingt oder umweltbedingt eine Änderung der Schaltparameter des Magnetsteuerventils vor, kann dies im Stand der Technik lediglich durch Auswertung des tatsächlich ausgesteuerten Bremsdruckes erfasst und entsprechend in einem Einlernvorgang angepasst werden. Dazu wird beispielsweise durch Anpassen der elektrischen Ansteuerung des jeweiligen Magnetsteuerventils über ein Steuersignal der Ist-Bremsdruck auf den Soll-Bremsdruck geregelt.

Ist allerdings kostenbedingt oder platzbedingt kein Drucksensor hinter dem Magnetsteuerventil vorhanden, ist bei der Festlegung des Steuersignals zur Ansteuerung des jeweiligen Magnetsteuerventils auf die beispielsweise am Bandende durchgeführte Parametrierung zurückzugreifen. Diese kann aber beispielsweise umgebungsbedingt oder aufgrund der Auslegung des aktuellen Bremssystems leicht von den tatsächlichen Schaltparametern abweichen, was zu einer ungenauen Ansteuerung der Betriebsbremsen führen kann, beispielsweise zu einer ungewollt asymmetrischen Ansteuerung von Betriebsbremsen an unterschiedlichen Rädern einer Fahrzeugachse.

Es ist daher Aufgabe der Erfindung, ein Verfahren zum Einlernen von Schaltparametern eines Magnetsteuerventils anzugeben, mit dem ein Magnetsteuerventil in einem Bremssystem in einfacher und zuverlässiger Weise parametriert werden kann. Weiterhin ist Aufgabe der Erfindung, ein Bremssystem zum Durchführen des Verfahrens anzugeben.

Diese Aufgabe wird durch ein Verfahren nach Anspruch 1 sowie ein Bremssystem nach Anspruch 22 gelöst. Bevorzugte Weiterbildungen sind in den Unteransprüchen angegeben.

Erfindungsgemäß ist demnach vorgesehen, zum Einlernen von Schaltparametern eines Magnetsteuerventils in einem Bremssystem eines Fahrzeuges, insbesondere Nutzfahrzeuges, Fahrdynamik-Änderungsgrößen zu ermitteln, die sich infolge von mindestens zwei ausgesteuerten Testbremsung ergeben, und in Abhängigkeit dieser Fahrdynamik-Änderungsgrößen einen zur Festlegung der Testbremsungen verwendeten Schaltparameter-Ausgangswert anzupassen und dadurch einen in etwa tatsächlich gültigen Schaltparameter einzulernen, der zum elektrischen Aussteuern von darauffolgenden Bremsungen mit dem betreffenden Magnetsteuerventil als verlässlich angenommen werden kann.

Dadurch wird erfindungsgemäß bereits der Vorteil erreicht, dass eine Anpassung der Schaltparameter-Ausgangswerte des betreffenden Magnetsteuerventils auch ohne das Erfassen eines Bremsdruckes über einen Drucksensor stattfinden kann und stattdessen auf die direkte Reaktion des Fahrzeuges auf die Testbremsungen zurückgegriffen wird. Diese Reaktion kann mit im Fahrzeug ohnehin notwendigen und vorhandenen Sensoren, beispielsweise Drehzahlsensoren oder Längsbeschleunigungssensoren, ermittelt werden, so dass Kosten und Platz für den Drucksensor im Bremssystem gespart werden können.

Als Schaltparameter werden im Rahmen der Erfindung für das jeweilige Magnetsteuerventil spezifische Zeitdauern bezeichnet, die eine Schaltverzögerung charakterisieren, d.h. eine Zeitdauer, in der das Magnetsteuerventil nach einer elektrischen Ansteuerung nicht reagiert und sich demnach auch keine Reaktion des Fahrzeuges, d.h. eine Änderung der Fahrdynamik des Fahrzeuges, auf diese Ansteuerung einstellen kann. Als Schaltparameter-Ausgangswerte können hierbei beispielsweise produktionsbedingte Schätzwerte vom Bandende oder vorab bereits eingelernte Schaltparameter für das Magnetsteuerventil verwendet werden.

Der Schaltparameter kann beispielsweise eine Einschaltdauer sein, die die Zeitdauer angibt, zwischen einer Ansteuerung des betreffenden Magnetsteuerventils über einen über ein Steuersignal übertragenen Ansteuerpuls und einer sich daraus ergebenden Bewegung eines Magnetankers, durch die das betreffende Magnetsteuerventil aktiviert wird und durch die demnach eine bestimmte Reaktion des Fahrzeuges erfolgen kann. Weiterhin wird als Schaltparameter eine Abschaltdauer bezeichnet, die die Zeitdauer angibt, zwischen dem Wegfall des Ansteuerpulses und dem Zurückfallen des beispielsweise federvorgespannten Magnetankers, wodurch das betreffende Magnetsteuerventil deaktiviert wird und eine entsprechende Reaktion des Fahrzeuges im Rahmen der jeweiligen Testbremsung erfolgen kann. Weiterhin kann als Schaltparameter auch eine beliebige von der Einschaltdauer und der Abschaltdauer abhängige Größe verstanden werden, die ebenfalls die Schaltverzögerung des Magnetsteuerventils charakterisiert, beispielsweise auch eine Gesamtschaltdauer, die im Folgenden aus einer Differenz aus Einschaltdauer und Abschaltdauer folgt.

Das Einlernen der Schaltparameter kann hierbei für Magnetsteuerventile erfolgen, die als "normally-closed" Magnetventile oder als "normally-open" Magnetsteuerventile ausgeführt sind. In einem den Bremsdruck an Betriebsbremsen des Fahrzeuges aussteuernden Modulator sind hierbei normalerweise als Einlassventile "normally-closed" Magnetsteuerventile angeordnet und als Auslassventile "normally-open" Magnetsteuerventile.

Um die Schaltparameter der Einlassventile im Rahmen des erfindungsgemäßen Verfahrens einzulernen, ist mit diesen eine Änderung der Fahrdynamik durch mindestens zwei Testbremsungen zu veranlassen. Dies geschieht durch eine Aktivierung des betreffenden Einlassventils über eine Ansteuerung mit mindestens einem Ansteuerpuls, durch den das Einlassventil geöffnet wird und ein Erhöhen des Bremsdruckes an den Betriebsbremsen stattfinden kann.

Gleichzeitig ist dafür zu sorgen, dass das im selben Modulator angeordnete Auslassventil geschlossen bleibt.

Um die Schaltparameter der Auslassventile im Rahmen des erfindungsgemäßen Verfahrens einzulernen, ist mit diesen ebenfalls eine Änderung der Fahrdynamik durch mindestens zwei Testbremsungen zu veranlassen. Dies geschieht durch eine Deaktivierung des betreffenden Auslassventils, d.h. durch eine Nicht-Ansteuerung über einen sog. Nicht-Ansteuerpuls. D.h. das betreffende Auslassventil wird zwischen Ansteuerpulsen für eine bestimmte Zeitdauer nicht angesteuert und verbleibt dadurch in seiner normalerweise geöffneten ("normally-open") Stellung, in der der Bremsdruck in den Betriebsbremsen durch eine Entlüftung reduziert wird und dadurch eine Änderung der Fahrdynamik stattfinden kann. Gleichzeitig ist für eine Deaktivierung der Einlassventile zu sorgen, um eine kontrollierte Änderung der Fahrdynamik zu ermöglichen.

Unter Kenntnis eines Ansprechdruckes der jeweiligen Betriebsbremse können also insbesondere die genannten Schaltparameter des Magnetsteuerventils direkt aus der Änderung der Fahrdynamik des Fahrzeuges ermittelt werden. Vorzugsweise werden die Testbremsungen dazu zu einem Zeitpunkt durchgeführt, zu dem keine weiteren Bremsanforderungen umgesetzt werden, so dass sichergestellt werden kann, dass die Reaktion des Fahrzeuges lediglich infolge der Ansteuerung oder Nicht-Ansteuerung des jeweiligen Magnetsteuerventils erfolgt, über das die Testbremsungen ausgelöst wird.

Zum Aussteuern der mindestens zwei Testbremsungen wird zunächst eine Fahrzeug-Test-Beschleunigung festgelegt, mit der das Fahrzeug im Rahmen der beiden Testbremsungen abgebremst werden soll. Um den Fahrer nicht zu stören und auch keine nicht-linearen Effekte bei der Auswertung der Reaktion des Fahrzeuges zu erhalten, ist die Fahrzeug-Test-Beschleunigung gering zu wählen, ohne dabei allerdings den bereits bekannten Ansprechdruck der jeweiligen Betriebsbremse zu unterschreiten, da eine Reaktion des Fahrzeuges zum Einlernen der Schaltparameter erforderlich ist.

Aus der Fahrzeug-Test-Beschleunigung ist anschließend für jede Testbremsung eine Test-Pulsfolge zu ermitteln, wobei jede Test-Pulsfolge eine gewisse Anzahl an Ansteuerpulsen und/oder Nicht-Ansteuerpulsen aufweist und die jeweilige Test-Pulsfolge in Abhängigkeit der Schaltparameter-Ausgangswerte für das betreffende Magnetsteuerventil ermittelt wird. Mit der jeweiligen Test-Pulsfolge wird das Magnetsteuerventil anschließend angesteuert bzw. nicht angesteuert, so dass sich eine Veränderung des Bremsdruckes und auch eine Änderung der Fahrdynamik des Fahrzeuges ergeben. Diese Änderung der Fahrdynamik wird in Form der Fahrdynamik-Änderungsgröße für jede Test-Pulsfolge erfasst, wobei die Fahrdynamik-Änderungsgröße beispielsweise eine Fahrzeug-Ist-Beschleunigung oder eine Drehzahl-Ist-Änderung oder eine daraus folgende Schlupfänderung sein kann, die über den Längsbeschleunigungssensor und/oder die Drehzahlsensoren im Fahrzeug erfasst werden kann. In Abhängigkeit davon findet anschließend die Anpassung der Schaltparameter-Ausgangswerte statt.

Vorzugsweise werden die Schaltparameter-Ausgangswerte hierbei lediglich dann angepasst, wenn die jeweilige Fahrdynamik-Änderungsgröße außerhalb eines Toleranzbandes um einen erwarteten Wert für die jeweilige Fahrdynamik-Änderungsgröße liegt, wobei der erwartete Wert beispielsweise die jeweilige Fahrzeug-Test-Beschleunigung bzw. eine Drehzahl-Soll-Änderung oder eine Soll-Schlupfänderung sein kann, die jeweils in einfacher Weise die infolge der jeweiligen Testbremsung zu erwartende Reaktion des Fahrzeuges angeben. Diese Soll-Größen können in einfacher Weise ermittelt werden bzw. sind im Rahmen des Einlernvorganges bereits bekannt.

Vorzugsweise ist vorgesehen, dass zum Ermitteln der Test-Pulsfolgen für jeden Ansteuerpuls der Test-Pulsfolge eine Test-Pulsdauer und/oder für jeden Nicht-Ansteuerpuls der Test-Pulsfolge eine Test-Pausendauer festgelegt wird, die jeweils abhängig sind von der Anzahl an Ansteuerpulsen bzw. Nicht-Ansteuerpulsen je Test-Pulsfolge sowie von der festgelegten Fahrzeug-Test-Beschleunigung sowie von den Schaltparameter-Ausgangswerten. Die Test-Pulsdauer gibt hierbei die Dauer jedes der Ansteuerpulse und die Test-Pausendauer die Dauer jedes der Nicht-Ansteuerpulse der jeweiligen Test-Pulsfolge an.

Die Test-Pulsdauer für die jeweilige Test-Pulsfolge ist hierbei abhängig von einer effektiven Test-Aktivierungsdauer, wobei die effektive Test-Aktivierungsdauer die Zeitdauer angibt, die das Magnetsteuerventil in seine aktivierte Stellung zu überführen ist, um eine Veränderung des Bremsdruckes an der Betriebsbremse derartig zu bewirken, dass die festgelegte Fahrzeug-Test-Beschleunigung auch umgesetzt wird. Diese ist insbesondere für den Einlernvorgang für das Einlassventil ("normally-closed") relevant. Diese effektive Test-Aktivierungsdauer zusammen mit einem Einschaltdauer-Ausgangswert und einem Abschaltdauer-Ausgangswert für das betreffende Magnetsteuerventil bzw. Einlassventil gibt die über das Steuersignal auszusteuernde Test-Pulsdauer pro Ansteuerpuls vor.

Entsprechend ist die Test-Pausendauer für die jeweilige Test-Pulsfolge abhängig von einer effektiven Test-Deaktivierungsdauer, wobei die effektive Test-Deaktivierungsdauer die Zeitdauer angibt, die das Magnetsteuerventil in seine deaktivierte Stellung zu überführen ist, um eine Veränderung des Bremsdruckes an der Betriebsbremse derartig zu bewirken, dass die festgelegte Fahrzeug-Test-Beschleunigung auch umgesetzt wird. Diese ist insbesondere für den Einlernvorgang für das Auslassventil ("normally-open") relevant. Diese effektive Test-Deaktivierungsdauer zusammen mit einem Einschaltdauer-Ausgangswert und einem Abschaltdauer-Ausgangswert für das betreffende Magnetsteuerventil bzw. Auslassventil gibt die über das Steuersignal auszusteuernde Test-Pausendauer pro Nicht-Ansteuerpuls vor.

Vorzugsweise werden die effektive Test-Aktivierungsdauer bzw. Test-Deaktivierungsdauer dazu für die festgelegte Fahrzeug-Test-Beschleunigung aus einer Kennlinie ermittelt, die den Zusammenhang zwischen beiden unter Berücksichtigung des bekannten Ansprechdruckes der jeweiligen Betriebsbremse angibt. Dadurch kann eine einfache und zuverlässige Umrechnung gewährleistet werden.

Sind mehrere Ansteuerpulse oder Nicht-Ansteuerpulse pro Test-Pulsfolge vorgesehen, ist die effektive Test-Aktivierungsdauer oder Test-Deaktivierungsdauer zur Bestimmung der Test-Pulsdauer bzw. Test-Pausendauer für jeden Ansteuerpuls bzw. Nicht-Ansteuerpuls vorzugsweise auf die Anzahl an Ansteuerpulsen bzw. Nicht-Ansteuerpulsen aufzuteilen und die Schaltparameter-Ausgangswerte für jeden Ansteuerpuls bzw. Nicht-Ansteuerpuls vollständig zu berücksichtigen. Dadurch kann vorteilhafterweise auch eine pulsweitenmodulierte Ansteuerung über mehrere Ansteuerpulse bzw. Nicht-Ansteuerpulse zum Bewirken der jeweiligen Testbremsung stattfinden.

Im Rahmen der Erfindung ist bevorzugt vorgesehen, eine erste Test-Pulsfolge aus einer ersten Anzahl an Ansteuerpulsen und/oder Nicht-Ansteuerpulsen zur Durchführung einer ersten Testbremsung und eine mindestens zweite Test-Pulsfolge aus einer zweiten Anzahl an Ansteuerpulsen und/oder Nicht-Ansteuerpulsen zur Durchführung einer mindestens zweiten Testbremsung zu ermitteln und dementsprechend mindestens zwei Test-bremsungen durchzuführen, wobei für jede Testbremsung bzw. jede Test-Pulsfolge dieselbe Fahrzeug-Test-Beschleunigung angesetzt wird, so dass auch die effektive Test-Aktivierungsdauer bzw. Test-Deaktivierungsdauer für jede Testbremsung identisch ist.

Damit sich die mindestens zwei Testbremsungen nicht gegenseitig beeinflussen, werden die mindestens zwei Test-Pulsfolgen zeitlich versetzt ausgesteuert, vorzugsweise aufeinanderfolgend, falls die Fahrsituation dies zulässt. Die mindestens zwei Testbremsungen können hierbei radweise an demselben oder achsweise an denselben Magnetsteuerventil(en) oder an unterschiedlichen Magnetsteuerventilen, die jeweils unterschiedlichen Betriebsbremsen an einer Fahrzeugachse des Fahrzeuges zugeordnet sind, durchgeführt werden.

Werden die mindestens zwei Testbremsungen radweise an demselben oder achsweise an denselben Magnetsteuerventilen durchgeführt, ist die Anzahl der Ansteuerpulse bzw. Nicht-Ansteuerpulse für jede Testbremsung unterschiedlich zu wählen. Ein Anpassen der Schaltparameter-Ausgangswerte findet in dem Fall lediglich dann statt, wenn eine erste Fahrdynamik-Änderungsgröße aus der ersten Testbremsung um mehr als einen Schwellenwert von einer zweiten Fahrdynamik-Änderungsgröße aus der zweiten Testbremsung abweicht. Dadurch wird sichergestellt, dass lediglich dann eine Anpassung stattfindet, wenn von der Erwartung abgewichen wird, dass beide Testbremsungen in etwa dieselbe Reaktion des Fahrzeuges verursachen, da die Fahrzeug-Test-Beschleunigung für die beiden Testbremsungen identisch sind. Durch einen Vergleich und Ansetzen eines Schwellenwertes kann dies in einfacher Weise erreicht werden.

Ist eine Anpassung der Schaltparameter-Ausgangswerte aufgrund der Überschreitung des Schwellenwertes nötig, findet diese vorzugsweise in Abhängigkeit einer Differenz aus den mindestens zwei ermittelten Fahrdynamik-Änderungsgrößen und/oder in Abhängigkeit einer Differenz aus aktuell ermittelten effektiven Ist-Aktivierungsdauern bzw. effektiven Ist-Deaktivierungsdauern statt, wobei die effektiven Ist-Aktivierungsdauern bzw. Ist-Deaktivierungsdauern aus den mindestens zwei Fahrdynamik-Änderungsgrößen folgen und dabei jeweils die Zeitdauer angeben, die das betreffende Magnetsteuerventil in seine aktivierte bzw. deaktivierte Stellung überführt wird, um die jeweilige Fahrdynamik-Änderungsgröße zu bewirken. Hierbei wird auch der Unterschied in der Anzahl an Ansteuerpulsen bzw. Nicht-Ansteuerpulsen zwischen den beiden Test-Bremsungen berücksichtigt.

Somit wird in einfacher und zuverlässiger Weise zurückgerechnet, welche Schaltparameter zu der aktuell vorliegenden Reaktion des Fahrzeuges auf die Testbremsungen passen, wobei dies vorteilhafterweise durch Erfassen des Unterschiedes in den jeweiligen Reaktionen des Fahrzeuges in Form einer Differenzbildung erfolgt. Da beide Testbremsungen mit unterschiedlichen Test-Pulsfolgen bzw. Test-Pausendauern durchgeführt werden, für beide Testbremsungen aber dieselben Schaltparameter gelten, ergibt sich daraus in einfacher Weise der aktuelle Wert für die Schaltparameter. Die Differenzbildung hat weiterhin den Vorteil, dass Umgebungseinflüsse, die in etwa identisch auf beide Testbremsungen wirken, herausfallen und somit nicht zu berücksichtigen sind.

Da beide Testbremsungen an demselben Magnetsteuerventil durchgeführt werden, gibt es zwei Möglichkeiten, gleiche Ausgangsbedingungen zu schaffen und dadurch nicht-lineare Effekte zu vermeiden. Entweder der Bremsdruck wird vor jeder Testbremsung auf einen vordefinierten Wert eingestellt oder aber der vor einer Testbremsung wirkende Bremsdruck wird abgeschätzt oder gemessen und bei der Analyse der Fahrdynamik-Änderungsgröße zum Anpassen der Schaltparameter-Ausgangswerte einbezogen. Der vordefinierte Wert kann hierbei bei einem Einlassventil durch den Atmosphärendruck gegeben sein, d.h. vor jeder Testbremsung werden die Bremszylinder entlüftet. Bei einem Auslassventil kann jedoch nur durch ein Entlüften eine Änderung der Fahrdynamik bewirkt werden, so dass vor einer Testbremsung mit dem Auslassventil ein bestimmter Bremsdruck einzustellen ist.

Das dem Verfahren zugrundeliegende Bremssystem kann insbesondere als ein elektropneumatisches Bremssystem ausgeführt sein, in dem über eine Steuereinrichtung elektrisch gesteuert Bremsdrücke eingestellt werden können. Die Magnetsteuerventile, für die die Schaltparameter einzulernen sind, sind in den Betriebsbremsen vorgeschalteten Modulatoren angeordnet und beispielsweise als Einlassventil und Auslassventile ausgeführt, die ein Druckerhöhen oder ein Druckreduzieren in den Bremszylindern wie beschrieben ermöglichen. Von der Steuereinrichtung werden Steuersignale ausgegeben, die die Test-Pulsfolgen übertragen und an die betreffenden Magnetsteuerventile im Modulator aussteuern, so dass diese entsprechend den Ansteuerpulsen und/oder Nicht-Ansteuerpulsen der Test-Pulsfolge mit einer Steuerspannung beaufschlagt oder nicht beaufschlagt werden. Die Ansteuerung kann hierbei vorzugsweise radweise oder achsweise erfolgen, um das Verfahren mit den entsprechenden Testbremsungen ausführen zu können. Somit ist in dem Bremssystem zumindest zum Durchführen des Verfahrens und somit zum Einlernen der Schaltparameter kein Drucksensor nötig.

Die Erfindung wird im Folgenden anhand der beiliegenden Zeichnungen näher erläutert. Es zeigen:

Fig. 1          eine schematische Ansicht eines Bremssystems im Bereich einer Hinterachse eines Fahrzeuges;

Fig. 2a, b    Ansteuerpulse und Nicht-Ansteuerpulse zur Ansteuerung eines Einlassventils und eines Auslassventils des Bremssystems gemäß Fig. 1;

Fig. 3a,      b eine Test-Pulsfolge für ein Einlassventil und ein Auslassventil zur Durchführung einer Testbremsung;

Fig. 4          zwei Test-Pulsfolgen zur Durchführung von zwei aufeinanderfolgenden Testbremsungen; und

Fig. 5          ein Flussdiagramm des erfindungsgemäßen Verfahrens.

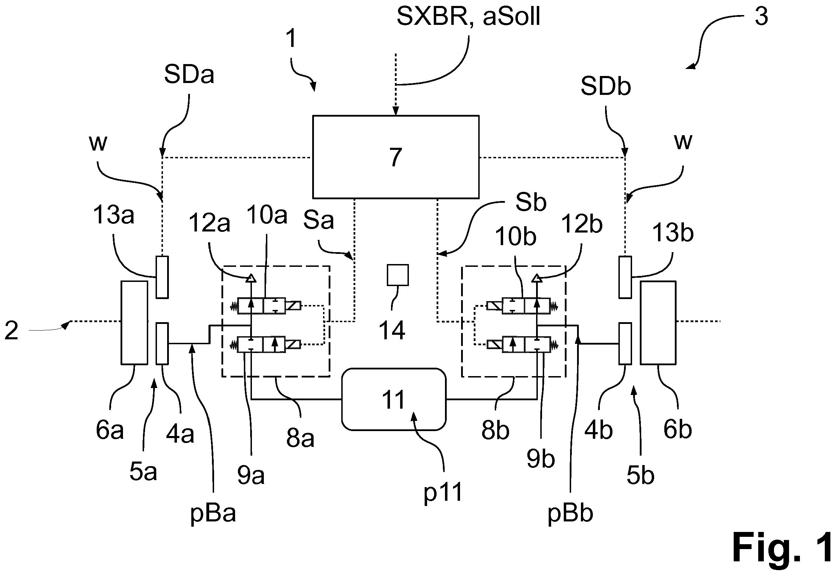

Fig. 1 zeigt beispielhaft und schematisch einen Ausschnitt eines Bremssystems 1 im Bereich einer Hinterachse 2 eines Fahrzeuges 3, wobei das Bremssystem 1 gemäß dieser Ausführungsform als ein pneumatisches Bremssystem ausgeführt ist. Demnach können durch Aufbau eines Bremsdruckes pBa, pBb in Bremszylindern bzw. Bremskammern 4a, 4b von Betriebsbremsen 5a, 5b die jeweiligen Räder 6a, 6b an der Hinterachse 2 gezielt abgebremst werden. Die Indizes "a" und "b" unterscheiden hierbei die Radseite an der Hinterachse 2, wobei "a" für die linke Seite und "b" für die rechte Seite steht.

Die Vorgabe des Bremsdruckes pBa, pBb in den Betriebsbremsen 5a, 5b an der Hinterachse 2 erfolgt elektropneumatisch, indem von einer Steuereinrichtung 7 des Bremssystems 1 Modulatoren 8a, 8b vor den jeweiligen Betriebsbremsen 5a, 5b mit einem Steuersignal Sa, Sb angesteuert werden. Gemäß der Ausführungsform in Fig. 1 weist jeder Modulator 8a, 8b jeweils ein Einlassventil 9a, 9b sowie ein Auslassventil 10a, 10b auf, die jeweils als Magnetsteuerventile bzw. Solenoid-Ventile ausgeführt sind und die über das Steuersignal Sa, Sb individuell angesteuert werden können.

Durch eine Ansteuerung des jeweiligen Magnetsteuerventils 9a, 9b, 10a, 10b über eine Pulsdauer tOn wird dieses in seine aktivierte Stellung überführt, wobei dazu für die Pulsdauer tOn eine Spannung an das jeweilige Magnetsteuerventil 9a, 9b, 10a, 10b vorgeben wird, die in einer Magnetspule des jeweiligen Magnetsteuerventils 9a, 9b, 10a, 10b einen Stromfluss und in Abhängigkeit davon eine Bewegung eines federvorgespannten magnetischen Ankers zur Aktivierung des Magnetsteuerventils 9a, 9b, 10a, 10b verursacht.

Die Magnetsteuerventile 9a, 9b, 10a, 10b können hierbei als "normally closed" Ventile ausgeführt sein, d. h. ohne eine Aktivierung sind die Magnetsteuerventile 9a, 9b, 10a, 10b in die geschlossene Stellung gestellt, oder als "normally open" Ventile, d. h. ohne eine Aktivierung sind die Magnetsteuerventile 9a, 9b, 10a, 10b in die geöffnete Stellung überführt. In den folgenden Ausführungsbeispielen sind die Einlassventile 9a, 9b als "normally closed" Ventile ausgeführt, d. h. um die Einlassventile 9a, 9b zu öffnen bzw. zu aktivieren, sind diese über eine gewisse Pulsdauer tOn anzusteuern. Die Auslassventile 10a, 10b hingegen sind als "normally open" Ventile ausgeführt, d. h. um die Auslassventile 10a, 10b zu schließen bzw. zu aktivieren, sind diese ebenfalls über eine gewisse Pulsdauer tOn anzusteuern. Ohne eine Ansteuerung sind die Auslassventile 10a, 10b demnach in die geöffnete Stellung und die Einlassventile 9a, 9b in die geschlossene Stellung gestellt, wobei die Zeitdauer, in der keine Ansteuerung stattfindet, im Folgenden als Pausendauer tOff bezeichnet wird.

Demnach kann durch die Vorgabe eines entsprechenden Steuersignals Sa, Sb das Einlassventil 9a, 9b und/oder das Auslassventil 10a, 10b des jeweiligen Modulators 8a, 8b individuell für eine bestimmte Zeitdauer aktiviert oder deaktiviert und dadurch der Bremsdruck pBa, pBb entsprechend eingestellt werden. Der Übersichtlichkeit halber wird für die betrachteten Zeitdauern im Folgenden auf eine Unterscheidung der Radseiten sowie der jeweiligen Magnetsteuerventile 9a, 9b, 10a, 10b durch einen Index verzichtet. Die Ermittlung und Festlegung der betrachteten Zeitdauern erfolgt jedoch individuell für jedes Magnetsteuerventil 9a, 9b, 10a, 10b einzeln.

Das Einlassventil 9a, 9b ist über eine Zuleitung mit einem Druckmittelvorrat 11 verbunden, in dem ein Druckmittel mit einem Vorratsdruck p11 gespeichert ist. Durch Öffnen des Einlassventils 9a, 9b kann das Druckmittel aus dem Druckmittelvorrat 11 in den Bremszylinder 4a, 4b der jeweiligen Betriebsbremse 5a, 5b einströmen und dadurch je nach Pulsdauer tOn für das betreffende Einlassventil 9a, 9b ein bestimmter Bremsdruck pBa, pBb an der Betriebsbremse 5a, 5b aufgebaut werden. Das Auslassventil 10a, 10b ist mit einem Entlüftungsanschluss 12a, 12b strömungsverbunden, wobei der Entlüftungsanschluss 12a, 12b wiederum in die Atmosphäre führt, so dass der jeweilige Bremszylinder 4a, 4b bei geöffnetem, d.h. deaktiviertem, Auslassventil 10a, 10b entlüftet werden kann und sich der Bremsdruck pBa, pBb dadurch je nach Pausenzeit tOff für das betreffende Auslassventil 10a, 10b reduziert.

Somit kann durch eine entsprechende Vorgabe der Pulsdauer tOff sowie der Pausendauer tOff für die betreffenden Magnetsteuerventile 9a, 9b, 10a, 10b der Bremsdruck pBa, pBb gehalten (Auslassventile 10a, 10b aktiviert und Einlassventile 9a, 9b deaktiviert), erhöht (Auslassventile 10a, 10b aktiviert und Einlassventile 9a, 9b aktiviert) und reduziert (Auslassventile 10a, 10b deaktiviert und Einlassventile 9a, 9b deaktiviert) werden.

Die über das jeweilige Steuersignal Sa, Sb erfolgende Vorgabe der Pulsdauer tOn sowie der Pausendauer tOff für das betreffende Magnetsteuerventil 9a, 9b, 10a, 10b und somit des einzustellenden Bremsdruckes pBa, pBb an der jeweiligen Radseite der Hinterachse 2 erfolgt über die Steuereinrichtung 7. Diese kann die Steuersignale Sa, Sb beispielsweise im Rahmen einer Bremsschlupfregelung in Abhängigkeit eines Drehzahlsensor-Signals SDa, SDb, das von einem Drehzahlsensor 13a, 13b an der jeweiligen Radseite bereitgestellt wird, vorgeben und/oder in Abhängigkeit eines von extern übermittelten XBR-Signals SXBR, das von einem beliebigen Fahrassistenzsystem im Fahrzeug 2 ausgegeben wird und beispielsweise eine von dem Bremssystem 1 einzustellende Fahrzeug-Soll-Beschleunigung aSoll in Form eines Verzögerungswunsches überträgt.

Die Steuereinrichtung 7 gibt in Abhängigkeit dieser Signale SDa, SDb, SXBR individuell Pulsdauern tOn bzw. Pausendauern tOff an das entsprechende Magnetsteuerventil 9a, 9b, 10a, 10b vor, um gemäß einer bestimmten Regelstrategie die Bremsdrücke pBa, pBb einzustellen und damit die Anforderungen umzusetzen.

Um eine präzise Umsetzung der jeweiligen Anforderung zu ermöglichen, sind von der Steuereinrichtung 7 Schaltparameter bzw. Schaltdauern zu berücksichtigen, die für jedes der Magnetsteuerventile 9a, 9b, 10a, 10b eine Schaltcharakteristik vorgeben und die jeweils bei der Abschätzung bzw. Berechnung einbezogen werden, welche Pulsdauer tOn bzw. welche Pausendauer tOff in etwa welchem auszusteuernden Bremsdruck pBa, pBb und somit welcher Fahrzeug-Soll-Beschleunigung aSoll entspricht. Als Schaltparameter werden hierbei insbesondere eine Einschaltdauer tE und eine Abschaltdauer tA des jeweiligen Magnetsteuerventils 9a, 9b, 10a, 10b verstanden, die eine Schaltverzögerung des jeweiligen Magnetsteuerventils 9a, 9b, 10a, 10b angeben, d.h. eine Zeitdauer, in der über das jeweilige Steuersignal Sa, Sb zwar eine Änderung des Schaltzustandes des jeweiligen Magnetsteuerventils 9a, 9b, 10a, 10b angefordert wird, dieses jedoch nicht auf diese Anforderung reagiert und die Änderung der Fahrdynamik des Fahrzeuges 3 somit trotz einer Ansteuerung unverändert bleibt.

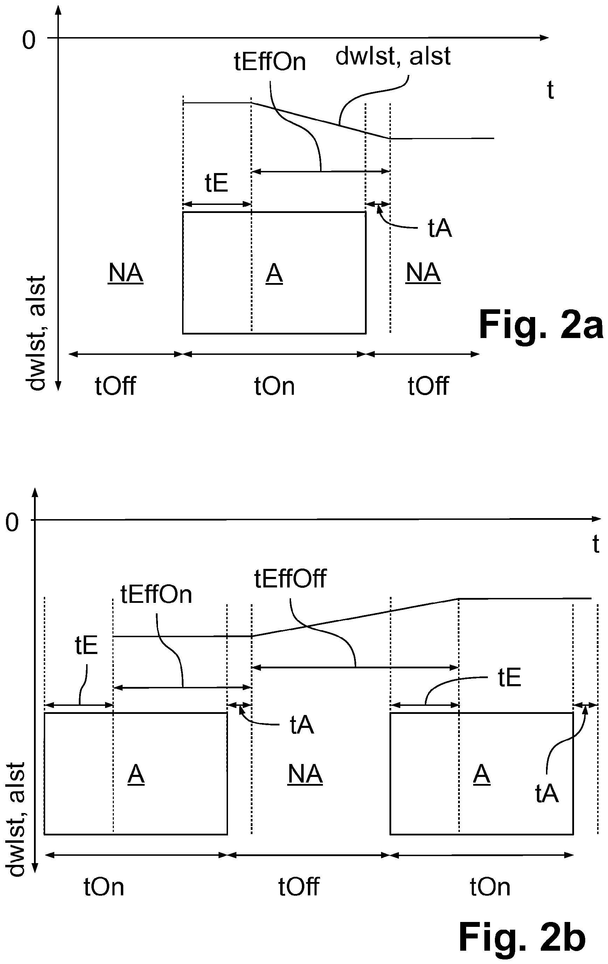

In den Fig. 2a und 2b sind beispielhaft über das Steuersignal Sa, Sb ausgegebene Ansteuerpulse A mit einer gewissen Pulsdauer tOn sowie daran angrenzende Pausen oder sog. Nicht-Ansteuerpulse NA, in denen über eine gewisse Pausenzeit tOff keine Ansteuerung stattfindet, sowie die entsprechenden Schaltparameter tE, tA für ein Einlassventil 9a, 9b (Fig. 2a) sowie ein Auslassventil 10a, 10b (Fig. 2b) eines beliebigen Modulators 8a, 8b dargestellt.

Weiterhin zeigen die Figuren Fig. 2a, 2b die Reaktion des Fahrzeuges 3 auf diese Ansteuerungen bzw. Nicht-Ansteuerungen und dabei im Speziellen eine Änderung der Fahrdynamik des Fahrzeuges 3 in Form eines zeitlichen Verlaufes einer Drehzahl-Ist-Änderung dwIst, die die Änderung einer von den Drehzahlsensoren 13a, 13b gemessenen Drehzahl w der Räder 6a, 6b des Fahrzeuges 3 pro Zeitintervall und damit eine zu einer Fahrzeug-Ist-Beschleunigung aIst proportionale Größe angibt. Somit stellen die Figuren lediglich einen qualitativen Verlauf der Änderung der Fahrdynamik dar.

Die Einschaltdauer tE gibt hierbei an, nach welcher Zeitdauer nach einer Ansteuerung über das jeweilige Steuersignal Sa, Sb, d. h. nach dem Aufbau einer Spannung an einem Steuereingang des entsprechenden Magnetsteuerventils 9a, 9b, 10a, 10b, dieses in seine aktivierte Stellung übergeht. Die Einschaltdauer tE wird hierbei dadurch beeinflusst, wie schnell nach Anlegen der Spannung infolge des Steuersignals Sa, Sb eine in dem Magnetsteuerventil 9a, 9b, 10a, 10b vorhandene Magnetspule ein Magnetfeld aufbaut und dieses einen federvorgespannten magnetischen Anker gegen eine Federkraft bewegt, um das Magnetsteuerventil 9a, 9b, 10a, 10b zu aktivieren.

Bei einem Einlassventil 9a, 9b wird demnach bewirkt, dass - wie in Fig. 2a dargestellt - nach Ablauf der Einschaltdauer tE während einer Ansteuerung über die Pulsdauer tOn die Drehzahl-Ist-Änderung dwIst bzw. die Fahrzeug-Ist-Beschleunigung aIst geringer wird, da das Fahrzeug 3 ab dann durch das tatsächliche Öffnen des Einlassventils 9a, 9b infolge einer Aktivierung stärker abgebremst wird, wobei die Fahrzeug-Ist-Beschleunigung aIst sowie auch die Drehzahl-Ist-Änderung dwIst aufgrund der Abbremsung negativ sind, d.h. der Betrag der Fahrzeug-Ist-Beschleunigung aIst sowie auch der Betrag der Drehzahl-Ist-Änderung dwIst steigt. Hierbei wird angenommen, dass das Auslassventil 10a, 10b im selben Modulator 8a, 8b gleichzeitig aktiviert wird oder aktiviert bleibt, so dass das einströmende Druckmittel infolge der Aktivierung des Einlassventils 9a, 9b für einen Anstieg des Bremsdruckes pBa, pBb im jeweiligen Bremszylinder 4a, 4b sorgt, d.h. es wird ein Druckerhöhen im jeweiligen Bremszylinder 4a, 4b angefordert.

Bei einem Auslassventil 10a, 10b hingegen bleibt - wie in Fig. 2b gezeigt - nach Ablauf der Einschaltdauer tE während einer Ansteuerung über die Pulsdauer tOn die Drehzahl-Ist-Änderung dwIst bzw. die Fahrzeug-Ist-Beschleunigung aIst konstant, da der Bremsdruck pBa, pBb im jeweiligen Bremszylinder 4a, 4b ab dann durch das tatsächliche Schließen des Auslassventils 10a, 10b infolge der Aktivierung nicht mehr verändert wird und das Fahrzeug somit mit gleichbleibender Fahrzeug-Ist-Beschleunigung aIst abgebremst wird. Dies erfolgt unter der Annahme, dass das Einlassventil 9a, 9b im selben Modulator 8a, 8b gleichzeitig deaktiviert wird oder bleibt, d.h. es wird ein Druckhalten im jeweiligen Bremszylinder 4a, 4b angefordert.

Vergleichbar zur Einschaltdauer tE wird die Abschaltdauer tA des jeweiligen Magnetsteuerventils 9a, 9b, 10a, 10b dadurch vorgegeben, wie lang das jeweilige Magnetsteuerventil 9a, 9b, 10a, 10b aktiviert bleibt, nachdem die Spannung über das Steuersignal Sa, Sb wegfällt und sich das Magnetfeld in der Magnetspule abbaut, so dass der federvorgespannt magnetische Anker durch die Federkraft wieder zurückfällt. Bei herkömmlichen Magnetsteuerventilen 9a, 9b, 10a, 10b ist der Betrag der Einschaltdauer tE unterschiedlich zu dem Betrag der Abschaltdauer tA, vorzugsweise ist die Einschaltdauer tE betragsmäßig höher als die Abschaltdauer tA.

Bei einem Einlassventil 9a, 9b wird gemäß Fig. 2a nach Ablauf der Abschaltdauer tA bewirkt, dass die Drehzahl-Ist-Änderung dwIst bzw. die Fahrzeug-Ist-Beschleunigung aIst konstant bleibt, da das Einlassventil 9a, 9b erst bei Ablauf der Abschaltdauer tA tatsächlich geschlossen wird, d. h. kein weiterer Bremsdruckaufbau erfolgt und das Fahrzeug 3 somit mit gleichbleibender Fahrzeug-Ist-Beschleunigung aIst abgebremst wird. Hierbei wird wieder angenommen, dass das Auslassventil 10a, 10b im selben Modulator 8a, 8b gleichzeitig aktiviert wird oder bleibt, d. h. ein Druckhalten in den Bremszylindern 4a, 4b angefordert wird.

Bei einem Auslassventil 10a, 10b hingegen wird gemäß Fig. 2b nach Ablauf der Abschaltdauer tA bewirkt, dass sich die Drehzahl-Ist-Änderung dwIst bzw. die Fahrzeug-Ist-Beschleunigung aIst in Richtung Null erhöht bzw. betragsmäßig verringert, da das Auslassventil 9a, 9b erst nach Ablauf der Abschaltdauer tA tatsächlich geöffnet wird, d. h. bei gleichzeitig deaktiviertem Einlassventil 9a, 9b der Bremsdruck pBa, pBb in den Bremszylindern 4a, 4b in den Entlüftungsanschluss 12a abgelassen und daher verringert und das Fahrzeug 3 dadurch weniger stark abgebremst wird.

Beide Zeitdauern tE, tA tragen also dazu bei, dass die über das Steuersignal Sa, Sb angeforderte Pulsdauer tOn bzw. die Pausendauer tOff zwischen den Ansteuerpulsen A nicht der Zeitdauer entspricht, in der sich das jeweilige Magnetsteuerventil 9a, 9b, 10a, 10b tatsächlich in seiner aktivierten bzw. deaktivierten Stellung befindet und in der somit weiterhin ein ungewolltes Druckhalten, Druckaufbauen oder ein Druckreduzieren stattfinden kann.

Das jeweilige Magnetsteuerventil 9a, 9b, 10a, 10b bleibt demnach bei einer gewissen über das Steuersignal Sa, Sb vorgegebenen Pulsdauer tOn für eine im Folgenden als effektive Aktivierungsdauer tEffOn bezeichnete Zeitdauer tatsächlich aktiviert, wobei sich die effektive Aktivierungsdauer tEffOn ergibt aus tEffOn = tOn - tE + tA. Analog bleibt das jeweilige Magnetsteuerventil 9a, 9b, 10a, 10b bei Vorgabe einer gewissen Pausendauer tOff zwischen zwei Ansteuerpulsen A für eine im Folgenden als effektive Deaktivierungsdauer tEffOff bezeichnete Zeitdauer tatsächlich deaktiviert, wobei sich die effektive Deaktivierungsdauer tEffOff ergibt aus tEffOff = tOff - tA + tE.

Die beiden Schaltdauern tE, tA eines bestimmten Magnetsteuerventils 9a, 9b, 10a, 10b werden im Folgenden auch in einer Gesamtschaltdauer P = tE - tA zusammengefasst, die die Zeitdauer angibt, in der das jeweilige Magnetsteuerventil 9a, 9b, 10a, 10b während eines Ansteuerpulses A (Einschalten und Abschalten) zwar reagiert aber sich keine Änderung der Fahrdynamik des Fahrzeuges 3 ergibt. Somit können die effektiven Schaltdauern tEffOn, tEffOff auch beschrieben werden durch:

$$tEffOn = tOn - P \text{ bzw. } tEffOff = tOff + P$$

Das Vorzeichen der Gesamtschaltdauer P ergibt sich dabei daraus, dass die effektive Aktivierungsdauer tEffOn durch die Einschaltdauer tE verkürzt und durch die Abschaltdauer tA verlängert wird. Entsprechend umgedreht gilt dies für die Deaktivierungsdauer tEffOff. Auch die Gesamtschaltdauer P kann als Schaltparameter in der Steuereinrichtung 7 gespeichert sein.

Für eine exakte Einstellung des Bremsdruckes pBa, pBb bzw. einer vorgegebenen Fahrzeug-Soll-Beschleunigung aSoll ist es also entscheidend, diese Zeitdauern tE, tA, tEffOn, tEffOff, P für jedes der Magnetsteuerventile 9a, 9b, 10a, 10b in den Modulatoren 8a, 8b möglichst genau zu bestimmen bzw. zu kennen und als Schaltparameter in der Steuereinrichtung 7 entsprechend abzuspeichern. Da sich die Abschaltdauer tA und die Einschaltdauer tE aber umweltbedingt ändern können und auch für jedes Magnetsteuerventil 9a, 9b, 10a, 10b bzw. in jedem Bremssystem 1 toleranzbedingt unterschiedlich ausfallen können, ist eine entsprechend genaue Parametrierung auf der Steuereinrichtung 7 erforderlich.

Dazu ist im Folgenden in unterschiedlichen Ausführungsformen ein Verfahren zum Abschätzen dieser Schaltdauern tE, tA bzw. Schaltparameter beschrieben, das in der Steuereinrichtung 7 während der Fahrt durchgeführt werden kann und dazu dient, die Schaltparameter tE, tA für einzelne Magnetsteuerventile 9a, 9b, 10a, 10b einzulernen, um die Genauigkeit einer elektropneumatisch durchgeführten Bremsung zu verbessern. Dazu werden von der Steuereinrichtung 7 koordiniert ein oder mehrere Testbremsungen durch Ansteuerung der betreffenden Magnetsteuerventile 9a, 9b, 10a, 10b, vorzugsweise achsweise, durchgeführt, die um den Fahrer nicht zu stören beispielsweise vor einer extern über das XBR-Signal SXBR angeforderten Bremsung eingefügt werden können. Wird demnach in der Steuereinrichtung 7 festgestellt, dass über das XBR-Signal SXBR eine bestimmte Fahrzeug-Soll-Beschleunigung aSoll von extern angefordert wurde, wird eine dieser Fahrzeug-Soll-Beschleunigung aSoll entsprechende Pulsdauer tOn und somit auch daraus folgende Pausendauern tOff über das Steuersignal Sa, Sb erst verzögert, beispielsweise um 100ms, an das jeweils zutreffende Magnetsteuerventil 9a, 9b, 10a, 10bim jeweiligen Modulator 8a, 8b zur Umsetzung der Fahrzeug-Soll-Beschleunigung aSoll ausgegeben.

Durch diese verzögerte Ausgabe der extern angeforderten Bremsung kann über das Steuersignal Sa, Sb eine Testbremsung mit den entsprechenden Magnetsteuerventilen 9a, 9b, 10a, 10b eingefügt werden. Zum Bewirken einer derartigen Testbremsung wird mindestens eines der Magnetsteuerventile 9a, 9b, 10a, 10b mit einer ersten Test-Pulsfolge PF1 angesteuert. Dazu wird zunächst eine Fahrzeug-Test-Beschleunigung aTest festgelegt, mit der die Testbremsung durchgeführt werden soll. Anschließend wird aus einer Kennlinie, die insbesondere einen Ansprechdruck der jeweiligen Betriebsbremse 5a, 5b berücksichtigt, für diese festgelegte Fahrzeug-Test-Beschleunigung aTest eine effektive Test-Aktivierungsdauer tEffOnTest bzw. eine effektive Test-Deaktivierungsdauer tEffOffTest ausgelesen, wobei diese die Zeitdauern angeben, die das jeweilige zu testende Magnetsteuerventil 9a, 9b, 10a, 10b zu aktivieren bzw. zu deaktivieren ist, um einen bestimmten Bremsdruck pBa, pBb in den Bremszylindern 4a, 4b auszusteuern und dadurch die Fahrzeug-Test-Beschleunigung aTest zu bewirken.

Die effektiven Test-Zeitdauern tEffOnTest, tEffOffTest werden also derartig festgelegt, dass wie oben beschrieben ein Druckerhöhen oder ein Druckreduzieren in den Bremszylindern 4a, 4b stattfindet und demnach eine Änderung der Fahrdynamik bewirkt wird. Im Rahmen der Testbremsung wird anschließend die tatsächliche Änderung der Fahrdynamik ausgewertet, um daraus die tatsächlich vorliegenden Schaltparameter tA, tE zu ermitteln.

Um ein Aktivieren des jeweiligen Magnetsteuerventils 9a, 9b, 10a, 10b für die ermittelte effektive Test-Aktivierungsdauer tEffOnTest zu erreichen, ist das jeweilige Magnetsteuerventil 9a, 9b, 10a, 10b - wie oben beschrieben - in der ersten Test-Pulsfolge PF1 mit einer ersten Test-Pulsdauer tOn1 anzusteuern, die sich ergibt aus

$$tOn1 = tEffOnTest + tE0 - tA0 = tEffOnTest + P0.$$

Als Einschaltdauer tE wird hierbei ein Einschaltdauer-Ausgangswert tE0 und als Abschaltdauer tA ein Abschaltdauer-Ausgangswert tA0 bzw. als Gesamtschaltdauer P ein Gesamtschaltdauer-Ausgangswert P0 verwendet, wobei diese Ausgangswerte tE0, tA0, P0 auf der Steuereinrichtung 7 gespeichert sind und entweder aus einem vorherigen Einlernvorgang folgen oder auf produktionsbedingten Schätzwerten basieren.

Entsprechend gilt dies für ein Deaktivieren eines zu testenden Magnetsteuerventils 9a, 9b, 10a, 10b, wobei das jeweilige Magnetsteuerventil 9a, 9b, 10a, 10b - wie oben beschrieben - während einer ersten Test-Pausendauer tOff1 nicht anzusteuern ist, um die effektive Test-Deaktivierungsdauer tEffOffTest zu erreichen:

$$tOff1 = tEffOffTest - tE0 + tA0 = tEffOffTest - P0$$

Falls vorgesehen ist, in einer oder in mehreren Testbremsungen die Schaltdauern tE, tA eines oder mehrerer Einlassventile 9a, 9b mit dem erfindungsgemäßen Verfahren abzuschätzen, ist dieses mit der ersten Test-Pulsdauer tOn1 anzusteuern, da sich eine Änderung der Fahrdynamik lediglich dann ergibt, wenn das jeweilige Einlassventil 9a, 9b aktiviert wird. Das Auslassventil 10a, 10b im selben Modulator 8a, 8b bleibt in dem Fall ebenfalls aktiviert, um ein Druckerhöhen und somit die Änderung der Fahrdynamik zu ermöglichen.

Ist jedoch vorgesehen, in einer oder in mehreren Testbremsungen die Schaltdauern tE, tA eines oder mehrerer Auslassventile 10a, 10b mit dem erfindungsgemäßen Verfahren abzuschätzen, ist dieses während der ersten Test-Pausendauer tOff1 nicht anzusteuern, da sich eine Änderung der Fahrdynamik lediglich dann ergibt, wenn das jeweilige Auslassventil 10a, 10b aktiviert wird. Das Einlassventil 9a, 9b im selben Modulator 8a, 8b bleibt in dem Fall deaktiviert, um ein Druckreduzieren und somit die Änderung der Fahrdynamik zu ermöglichen. In dem Fall ist jedoch dafür zu sorgen, dass sich vor der Testbremsung ein gewisser Bremsdruck pBa, pBb in den Bremszylinder 4a, 4b aufgebaut ist, um ein Druckreduzieren zu ermöglichen.

Nach der Festlegung der entsprechenden Parameter und Variablen für die Testbremsung, wird also das jeweilige zu testende Magnetsteuerventil 9a, 9b, 10a, 10b über das Steuersignal Sa, Sb mit der ersten Test-Pulsfolge PF1 angesteuert und anschließend die Reaktion des Fahrzeuges 3 auf die Testbremsung ausgewertet, indem insbesondere eine erste Fahrdynamik-Änderungsgröße erfasst wird. Bevorzugt wird die Testbremsung hierbei achsweise durchgeführt, d. h. zum Bewirken der Testbremsung werden die Einlassventile 9a, 9b und/oder die Auslassventile 10a, 10b in beiden Modulatoren 8a, 8b z.B. an der Hinterachse 2 gleichzeitig angesteuert, wobei gemäß der im folgenden beschriebenen Ausführungsform des erfindungsgemäßen Verfahrens vorgesehen ist, dazu dieselbe erste Test-Pulsfolge PF1 an beide Seiten auszusteuern.

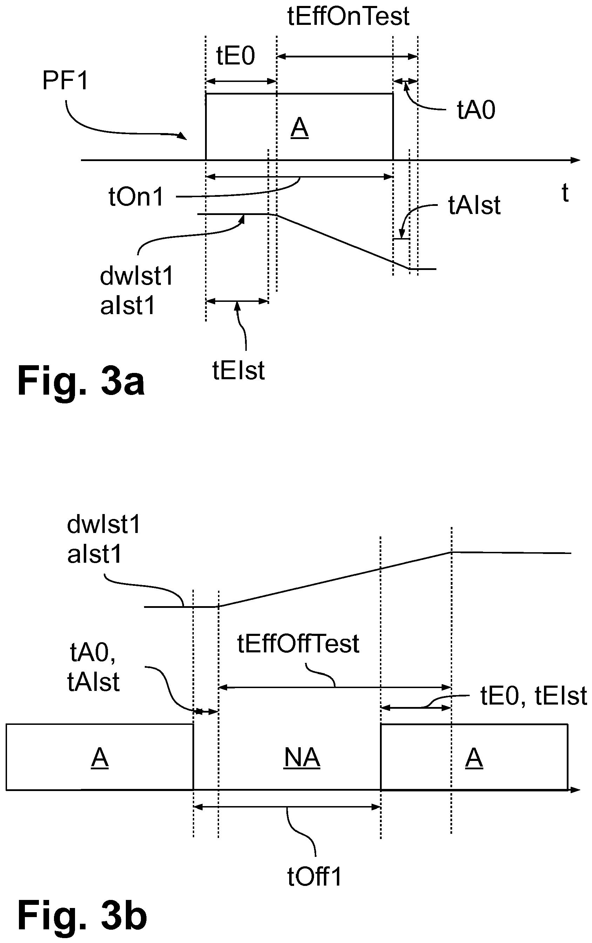

In der einfachsten Form wird hierbei bei den beiden zu testenden Einlassventilen 9a, 9b in den Modulatoren 8a, 8b an der Hinterachse 2 (Fig. 1) angenommen, dass die erste Test-Pulsfolge PF1 lediglich einen Ansteuerpuls A (erste Anzahl C1 = 1) aufweist und die Änderung der Fahrdynamik des Fahrzeuges 3 lediglich anhand dieses einen Ansteuerpulses A erfasst und ausgewertet wird, wie in Fig. 3a dargestellt ist. Sind die beiden zu testenden Magnetsteuerventile die Auslassventile 10a, 10b in den Modulatoren 8a, 8b der Hinterachse 2, wird zunächst ein Bremsdruck pBa, pBb in den Bremszylindern 4a, 4b aufgebaut bzw. ein bereits vorhandener Bremsdruck pBa, pBb z.B. in einer Druckhaltephase beibehalten und die beiden Auslassventile 10a, 10b anschließend für eine definierte erste Test-Pausendauer tOff1 deaktiviert und anschließend wieder aktiviert, so dass wie in Fig. 3b dargestellt ein Nicht-Ansteuerpuls NA ausgebildet wird. Die Änderung der Fahrdynamik wird also lediglich infolge einer einzigen (C1=1) ersten Test-Pausendauer tOff1 zwischen zwei Ansteuerpulsen A erfasst und ausgewertet.

Die die Änderung der Fahrdynamik infolge der ersten Test-Pulsfolge PF1 charakterisierende erste Fahrdynamik-Änderungsgröße kann hierbei durch eine tatsächlich vorliegende erste Fahrzeug-Ist-Beschleunigung aIst1 gegeben sein, die entweder direkt mit einem Längsbeschleunigungssensor 14 im Fahrzeug 3 gemessen oder aber aus den Drehzahlsensor-Signalen SDa, SDb der Drehzahlsensoren 13a, 13b berechnet wird. Dazu kann aus der zeitlichen Entwicklung bzw. der Änderung einer sich an einem beliebigen Rad 6a, 6b des Fahrzeuges 3 während der Testbremsung in einem Zeitintervall einstellenden ersten Drehzahl w1 eine erste Drehzahl-Ist-Änderung dwIst1 ermittelt werden und daraus die erste Fahrzeug-Ist-Beschleunigung aIst1. Alternativ kann im weiteren Verfahren auch direkt die erste Drehzahl-Ist-Änderung dwIst1 als erste Fahrdynamik-Änderungsgröße oder eine dazu proportionale Größe verwendet werden, da auch diese die Reaktion des Fahrzeuges 3 auf die Testbremsung charakterisiert.

Eine Auswertung der über die Sensoren 13a, 13b, 14 erfassten ersten Fahrdynamik-Änderungsgröße aIst1, dwIst1 erlaubt somit, eine direkte Reaktion des Fahrzeuges 3 auf die Testbremsung zu erfassen und somit den Einfluss der ersten Test-Pulsfolge PF1 auf das Fahrzeug 3 abzuschätzen. Wie in Fig. 3a beispielhaft gezeigt, liegt demnach bei einer Ansteuerung der beiden Einlassventile 9a, 9b, ein Einschaltdauer-Istwert tEIst für das jeweilige Einlassventil 9a, 9b vor, der von dem Einschaltdauer-Ausgangswert tE0 abweicht, wobei der Einschaltdauer-Istwert tEIst den tatsächlichen Wert der Einschaltdauer tE des jeweiligen Einlassventils 9a, 9b für die gerade durchgeführte Testbremsung angibt. Ein Abschaltdauer-Istwert tAIst weicht ebenfalls geringfügig von dem Abschaltdauer-Ausgangswert tA0 ab.

In Fig. 3b ist für die erste Testpulsfolge PF1 die Ansteuerung der beiden Auslassventile 10a, 10b über zwei Ansteuerpulse A dargestellt, wobei sich zwischen den beiden Ansteuerpulsen A die erste Test-Pausendauer tOff1 ergibt, die unter der Annahme der gezeigten Einschaltdauer-/Abschaltdauer-Ausgangswerte tA0, tE0 eine Reaktion des Fahrzeuges 3 bewirkt, für die angenommen werden kann, dass die Istwerte tAIst, tEIst mit den Ausgangswerten tA0, tE0 übereinstimmen.

Da eine exakte zeitliche Zuordnung der in den Figuren 3a und 3b dargestellten Istwerte tEIst, tAIst aufgrund von äußeren Einflüssen zu ungenau ist und somit ein direkter Vergleich mit den Ausgangswerten tE0, tA0 nicht mit hinreichender Genauigkeit möglich ist, kann eine Überprüfung, ob die Ausgangswerte tE0, tA0, P0 (Schaltparameter-Ausgangswerte) für das jeweilige Magnetsteuerventil 9a, 9b, 10a, 10b korrekt angenommen wurden oder diese anzupassen sind dadurch erfolgen, dass eine zweite Testbremsung mit einer zweiten Test-Pulsfolge PF2 an demselben Rad 6a, 6b wie die erste Testbremsung mit der ersten Test-Pulsfolge PF1 durchgeführt wird. Demnach werden an der Hinterachse 2 bevorzugt zunächst beide Einlassventile 9a, 9b oder Auslassventile 10a, 10b gleichzeitig mit der ersten Test-Pulsfolge PF1 und anschließend beide Einlassventile 9a, 9b oder Auslassventile 10a, 10b gleichzeitig mit der zweiten Test-Pulsfolge PF2 angesteuert, wobei sich die Test-Pulsfolgen PF1, PF2 in dem Fall unterscheiden. Grundsätzlich ist es aber auch möglich, die beiden Test-Pulsfolgen PF1, PF2 nacheinander an lediglich einem Rad 6a, 6b der Hinterachse 2 auszusteuern.

Durch eine derartige Durchführung der beiden Testbremsungen kann nicht nur der Zeitpunkt des Druckaufbaus bzw. die Einschaltdauer tE bzw. die Abschaltdauer tA des jeweiligen Magnetsteuerventils 9a, 9b, 10a, 10b überprüft werden, sondern auch der absolute Wert der ausgesteuerten Fahrzeug-Soll-Beschleunigung aSoll. D. h. es kann geprüft werden, ob eine mit den Schaltparameter-Ausgangswerten tE0, tA0, P0 ermittelte Pulsdauer tOn bzw. Pausendauer tOff tatsächlich zu der angeforderten Fahrzeug-Soll-Beschleunigung aSoll führen kann.

Die zweite Testbremsung kann hierbei bei Vorliegen einer extern angeforderten Bremsung je nach Verzögerung der Ausgabe des Steuersignals Sa, Sb zur verzögerten Umsetzung dieser extern angeforderten Bremsung direkt nach Abschluss der ersten Testbremsung und vor Durchführung der extern über das XBR-Signal SXBR angeforderten Bremsung eingefügt werden oder aber zum nächstmöglichen Zeitpunkt, beispielsweise vor einer weiteren extern angeforderten Bremsung.

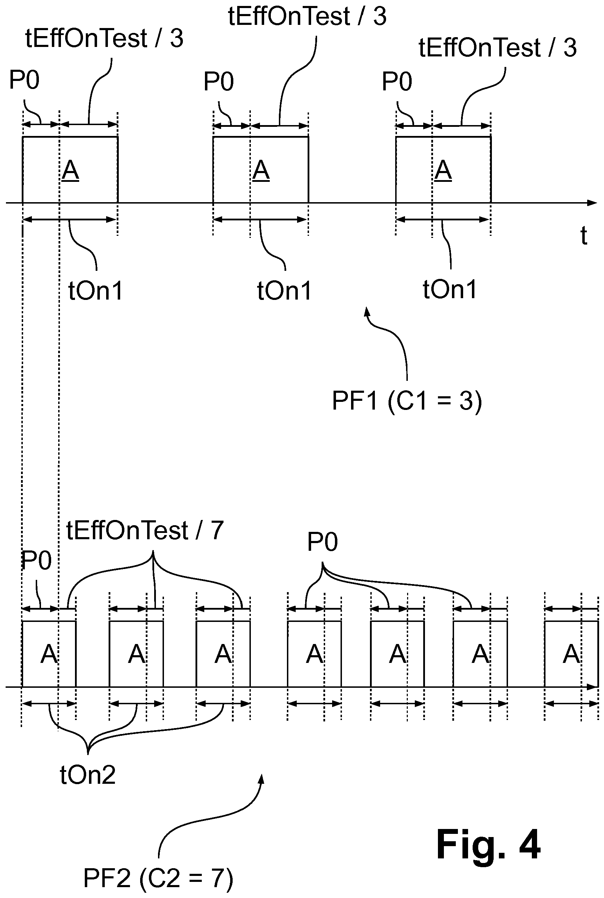

Gemäß Fig. 4 ist dies anhand von zwei Test-Pulsfolgen PF1, PF2 dargestellt, die an beiden Einlassventilen 9a, 9b der Hinterachse 2 zur Umsetzung durch die Betriebsbremsen 5a, 5b ausgesteuert werden. Analog ist dieses Vorgehen auch auf die Auslassventile 10a, 10b übertragbar, um mit diesen eine derartige Testbremsung durchzuführen. Die Festlegung der Test-Pulsfolgen PF1, PF2 geschieht wie folgt:
Zunächst wird wie oben ein Wert für die Fahrzeug-Test-Beschleunigung aTest festgelegt, der für beide Test-Pulsfolgen PF1, PF2 gilt. Aus der festgelegten Fahrzeug-Test-Beschleunigung aTest folgt wie oben beschrieben aus einer Kennlinie eine effektive Test-Aktivierungsdauer tEffOnTest, die ebenfalls für beide Test-Pulsfolgen PF1, PF2 gilt, da diese an dieselben Einlassventile 9a, 9b ausgesteuert werden.

Anschließend wird festgelegt, wie viele Ansteuerpulse A für die erste Test-Pulsfolge PF1 verwendet werden sollen. Gemäß Fig. 4 ist für die erste Test-Pulsfolge PF1 eine erste Anzahl C1 an Ansteuerpulsen A von drei vorgesehen (C1=3), d. h. die Fahrzeug-Test-Beschleunigung aTest wird beispielsweise durch ein pulsweitenmoduliertes Steuersignal Sa, Sb mit drei Ansteuerpulsen A für die Einlassventile 9a, 9b vorgegeben, über das unter Annahme eines gleichzeitig aktivierten Auslassventils 10a, 10b ein Druckaufbau in dem linken Bremszylinder 4a bewirkt wird. Dazu wird für die erste Test-Pulsfolge PF1 die zur Fahrzeug-Test-Beschleunigung aTest gehörende effektive Test-Aktivierungsdauer tEffOn-Test zu gleichen Teilen auf die drei Ansteuerpulse A verteilt, d. h. jeweils tEffOnTest / 3. Da jeder dieser drei Ansteuerpulse A vom selben Einlassventil 9a, 9b ausgeht, ist der Einschaltdauer-Ausgangswert tE0 sowie der Abschaltdauer-Ausgangswert tA0 für jeden Ansteuerpuls A identisch, so dass sich die erste Test-Pulsdauer tOn1, die für jeden der drei Ansteuerpulse A gilt, ergibt aus:

$$tOn1 = tE0 - tA0 + tEffOnTest / 3 = P0 + tEffOnTest / 3.$$

In Fig. 4 ist statt dem Einschaltdauer-Ausgangswert tE0 und dem Abschaltdauer-Ausgangswert tA0 für jeden Ansteuerpuls A der Gesamtschaltdauer-Ausgangswert P0 dargestellt.
Allgemein folgt somit für die erste Test-Pulsfolge PF1 aus einer ersten Anzahl C1 an Ansteuerpulsen A:

$$tOn1 = P0 + tEffOnTest/C1$$

Durch Aussteuern dieser ersten Test-Pulsfolge PF1 mit der o.g. ersten Test-Pulsdauer tOn1 für jeden der drei Ansteuerpulse A wird nun angenommen, dass sich die Fahrzeug-Test-Beschleunigung aTest einstellt, was durch die weitere Auswertung zu bestätigen ist.
Die zweite Test-Pulsfolge PF2 wird vergleichbar festgelegt, wobei gegenüber der ersten Test-Pulsfolge PF1 eine geänderte zweite Anzahl C2 an Ansteuerpulsen A verwendet wird, d. h. C1 =/= C2, wobei gemäß Fig. 4 eine zweite Anzahl C2 von sieben gewählt wurde. Somit wird dieselbe Bremswirkung, d.h. die Fahrzeug-Test-Beschleunigung aTest, mit einer unterschiedlichen Anzahl an Ansteuerpulsen A erzeugt. Mit dem Einschaltdauer-Ausgangswert tE0 sowie dem Abschaltdauer-Ausgangswert tA0 bzw. dem Gesamtschaltdauer-Ausgangswert P0, die jeweils mit den Ausgangswerten der ersten Testbremsung PF1 übereinstimmen, da dieselben Einlassventile 9a, 9b angesteuert werden, ergibt sich eine zweite Test-Pulsdauer tOn2 von:

$$tOn2 = tE0 - tA0 + tEffOnTest / 7 = P0 + tEffOnTest / 7.$$

Allgemein folgt für die zweite Test-Pulsfolge PF2 aus einer zweiten Anzahl C2 an Ansteuerpulsen A:

$$tOn2 = P0 + tEffOnTest/C2$$

In analoger Weise ergeben sich die beiden Test-Pausendauern tOff1, tOff2 für zwei derartige Testbremsungen mit den Auslassventilen 10a, 10b allgemein zu

$$tOff1 = - P0 + tEffOffTest/C1$$

$$tOff2 = - P0 + tEffOffTest/C2$$

d.h. mit umgekehrten Vorzeichen für den Gesamtschaltdauer-Ausgangswert P0, wobei die Anzahl C1, C2 hierbei nicht die Anzahl an Ansteuerpulsen A sondern die Anzahl an Nicht-Ansteuerpulsen NA angibt.
Um nun zu verifizieren, ob die Schaltparameter-Ausgangswerte tE0, tA0 bzw. der Gesamtschaltdauer-Ausgangswert P0 korrekt sind, werden im Anschluss an die Aussteuerung der jeweiligen Test-Pulsfolge PF1, PF2 die erste und eine zweite Fahrzeugdynamik-Änderungsgröße aIst1, aIst2, dwIst1, dwIst2, die die Reaktion des Fahrzeuges 3 auf die jeweilige Test-Pulsfolge PF1, PF2 angeben, erfasst und ausgewertet, wobei sichergestellt wird, dass diese Fahrzeugdynamik-Änderungsgrößen aIst1, aIst2, dwIst1, dwIst2 tatsächlich nur auf die jeweilige Testbremsung zurückzuführen sind. Dadurch kann die Reaktion des Fahrzeuges 3 auf die jeweilige Test-Pulsfolge PF1, PF2 quantitativ ermittelt werden, d.h. ob die tatsächlich erwartete Änderung, d.h. die Fahrzeug-Test-Beschleunigung aTest oder eine daraus folgende Drehzahl-Soll-Änderung dwSoll auch tatsächlich eingetreten ist.

Da für beide Testbremsungen derselbe Wert für die Fahrzeug-Test-Beschleunigung aTest angenommen wurde, sollten die erste Drehzahl-Ist-Änderung dwIst1, die sich aufgrund der ersten Test-Pulsfolge PF1 einstellt, und die zweite Drehzahl-Ist-Änderung dwIst2, die sich aufgrund der zweiten Test-Pulsfolge PF2 einstellt, sowie auch die gemessene erste Fahrzeug-Ist-Beschleunigung aIst1 und die zweite Fahrzeug-Ist-Beschleunigung aIst2 nach Abschluss der jeweiligen Testbremsung identische Werte aufweisen.

Hierbei werden für beide Testbremsungen, die zeitlich versetzt ausgeführt werden, vergleichbare Ausgangsbedingungen angenommen, was insbesondere dadurch erreicht wird, dass mit beiden Testbremsungen jeweils bei entlüftetem Bremszylinder 4a, 4b begonnen wird, d.h. es liegt vor den Test-bremsungen in etwa dasselbe Bremsverhalten vor. Bei Testbremsungen mit den Auslassventilen 10a, 10b ist entsprechend für beide Testbremsungen mit einem identischen Bremsdruck pBa, pBb zu beginnen, der durch eine Deaktivierung des Auslassventils 10a, 10b verringert werden kann, um eine messbare Reaktion des Fahrzeuges 3 zu verursachen. Ggf. wird also nach Durchführung der ersten Testbremsung der jeweilige Bremszylinder 4a, 4b zunächst entlüftet (oder belüftet) und dann erst mit der zweiten Testbremsung begonnen. Dazu wird vorzugsweise eine sehr geringe Fahrzeug-Test-Beschleunigung aTest festgelegt, um hohe Druckänderungen in den Bremszylindern 4a, 4b zu vermeiden. Alternativ kann auch der vor der Testbremsung wirkende Bremsdruck pBa, pBb im Bremszylinder 4a, 4b gehalten werden und ein bei Erhöhung (bzw. Reduzierung) des Bremsdruckes pBa, pBb infolge der Testbremsung bewirktes nichtlineares Bremsverhalten abgeschätzt und bei einer Auswertung der Testbremsungen einbezogen werden.

In der Steuereinrichtung 7 wird nach Durchführung der beiden Testbremsungen geprüft, ob beide Testbremsungen vergleichbare Reaktionen des Fahrzeuges 3 auslösen und für beide Testbremsungen das erwartete Bremsverhalten auch eingetreten ist. Dazu können die erste und die zweite Fahrdynamik-Änderungsgröße aIst1, aIst2, dwIst1, dwIst2 mit einem erwarteten Wert verglichen werden, d.h. die Fahrzeug-Ist-Beschleunigung aIst1, aIst2 für die jeweilige Testbremsung wird mit der Fahrzeug-Test-Beschleunigung aTest, die für beide Testbremsungen identisch ist, verglichen. Unter der Annahme eines korrekt angenommenen Abschaltdauer-Ausgangswertes tA0 und Einschaltdauer-Ausgangswertes tE0 sollte im beschriebenen Fall theoretisch gelten: aIst1 = aIst2 = aTest. Gleiches gilt für die Drehzahl-Ist-Änderung dwIst1, dwIst2, die jeweils einer aus der Fahrzeug-Test-Beschleunigung aTest folgenden Drehzahl-Soll-Änderung dwSoll, die ebenfalls für beide Test-bremsungen identisch ist, entsprechen sollte.

Ist dies der Fall, ist keine Anpassung der Schaltparameter tE, tA nötig und der auf der Steuereinrichtung 7 gespeicherte Abschaltdauer-Ausgangswert tA0 und der Einschaltdauer-Ausgangswert tE0 bzw. Gesamtschaltdauer-Ausgangswert P0 können für die folgenden Bremsungen beibehalten werden. Ein Beibehalten der Schaltparameter-Ausgangswerte tE0, tA0 erfolgt auch, wenn die Fahrdynamik-Änderungsgrößen aIst1, aIst2, dwIst1, dwIst2 jeweils innerhalb des Toleranzbandes B um den jeweils erwarteten Wert aTest, dwSoll liegen, um ungewollte Effekte durch eine häufige Anpassung der Schaltparameter tE, tA zu vermeiden. Das Toleranzband B kann hierbei beispielsweise einer maximalen Abweichung von 10% von dem erwarteten Wert entsprechen.

Liegt die jeweilige Fahrdynamik-Änderungsgröße aIst1, aIst2, dwIst1, dwIst2 außerhalb des Toleranzbandes B, wird geprüft, ob die Differenz aus den in den beiden Testbremsungen ermittelten Fahrdynamik-Änderungsgrößen, d.h. aIst1 - aIst2 bzw. dwIst1- dwIst2, größer ist als ein Schwellenwert E, der z.B. 10% beträgt. Ist dies nicht der Fall, ist keine Anpassung der Schaltparameter tE, tA nötig.

Liegt die jeweilige Fahrdynamik-Änderungsgröße aIst1, aIst2, dwIst1, dwIst2 außerhalb des Toleranzbandes B und überschreitet die Differenz den Schwellenwert E, ist eine Anpassung der Schaltparameter tE, tA nötig, die wie folgt ausgeführt wird:

Zunächst wird die Fahrzeug-Ist-Beschleunigung aIst1, aIst2, die sich nach Abschluss der jeweiligen Testbremsung nach dem Aussteuern der jeweiligen Test-Pulsfolge PF1, PF2 ergibt, zurückgerechnet, indem anhand einer Kennlinie geprüft wird, welche effektiven Ist-Aktivierungsdauern tEffOnIst1, tEffOnIst2 aus der jeweiligen Fahrzeug-Ist-Beschleunigung aIst1, aIst2 folgen. Bei einer Testbremsung mit den Auslassventilen 10a, 10b werden entsprechend Ist-Deaktivierungsdauern tEffOffIst1, tEffOffIst2 zurückgerechnet. Hierbei wird jeweils dieselbe Kennlinie zugrunde gelegt, aus der auch die effektive Test-Aktivierungsdauer tEffOnTest bzw. Test-Deaktivierungsdauer tEffOffTest für die vorab festgelegte Fahrzeug-Test-Beschleunigung aTest ermittelt wurde. Aus diesen beiden effektiven Ist-Aktivierungsdauern tEffOnIst1, tEffOnIst2 bzw. Ist-Deaktivierungsdauern tEffOffIst1, tEffOffIst2 wird anschließend zurückgerechnet, wie hoch ein Gesamtschaltdauer-Istwert PIst für beide Testbremsungen ist und wie dementsprechend der Gesamtschaltdauer-Ausgangswert P0 = tE0 - tA0 und somit implizit der Einschaltdauer-Ausgangswert tE0 und der Abschaltdauer-Ausgangswert tA0 für die nächste Bremsung mit dem entsprechenden Magnetsteuerventil 9a, 9b, 10a, 10b anzupassen sind.

Hierbei gilt für die Testbremsung gemäß Fig. 4:

$$tEffOnIst1 = (PIst - P0) \times 3 + tEffOnTest + FEnv$$

$$tEffOnIst2 = (PIst - P0) \times 7 + tEffOnTest + FEnv,$$

wobei FEnv einen umgebungsabhängigen Einflussfaktor angibt, der sich auf die Fahrzeug-Ist-Beschleunigung alst1, alst2 auswirkt. Ist der Gesamtschaltdauer-Istwert PIst gleich dem Gesamtschaltdauer-Ausgangswert P0, stimmen auch die beiden effektiven Ist-Aktivierungsdauern tEffOnIst1, tEffOnIst2, mit der Test-Aktivierungsdauer tEffOnTest bis auf den Einflussfaktor FEnv überein, so dass keine Anpassung nötig wäre.

Anschließend wird die Differenz tEffOnIst1 - tEffOnIst2 aus beiden Gleichungen gebildet, wodurch der Einflussfaktor FEnv herausfällt.D.h. es folgt:

$$tEffOnIst1 - tEffOnIst2 = (PIst - P0) \times (3 - 7)$$

bzw.

$$PIst = P0 + (tEffOnIst1 - tEffOnIst2) / (3 - 7).$$

Verallgemeinert auf eine beliebige Anzahl C1, C2 an Ansteuerpulsen A für die erste Test-Pulsfolge PF1 und die zweite Test-Pulsfolge PF2 ergibt sich somit der Gesamtschaltdauer-Istwert PIst für die beiden Testbremsungen aus

$$PIst = P0 + (tEffOnIst1 - tEffOnIst2) / (C1 - C2),$$

wobei C1 =/= C2.

Analog kann dies für die Auslassventile 10a, 10b in vergleichbarer Weise hergeleitet werden, so dass für den Gesamtschaltdauer-Istwert PIst der Auslassventile 10a, 10b gilt:

$$PIst = P0 + (tEffOffIst1 - tEffOffIst2) / (C1 - C2),$$

wobei C1 =/= C2.

Um den Gesamtschaltdauer-Istwert PIst zu erhalten, ist also lediglich erforderlich, zwei - oder auch mehrere - Testbremsungen durchzuführen und deren Reaktion in Form der Fahrdynamik-Änderungsgröße alst1, alst2, dwIst1, dwIst2 zu erfassen und für die Einlassventile 9a, 9b in die effektiven Ist-Aktivierungsdauern tEffOnIst1, tOnEffIst2 bzw. für die Auslassventile 10a, 10b in die effektiven Ist-Deaktivierungsdauern tEffOffIst1, tEffOffIst2 umzurechnen. In beiden Testbremsungen konstant bleibende Einflüsse können durch die Differenzbildung unberücksichtigt bleiben. Weiterhin wird angenommen, dass sich Umweltbedingungen, d.h. insbesondere Spannungen bei der Ansteuerung der Magnetsteuerventile 9a, 9b, 10a, 10b, die Umgebungstemperatur, Reifeneigenschaften, Bremseigenschaften, Fahrbahneigenschaften oder dergleichen, zwischen den beiden Testbremsungen nicht signifikant ändern.

Unter den oben genannten Bedingungen kann der Gesamtschaltdauer-Istwert PIst als Gesamtschaltdauer-Ausgangswert P0 für die folgenden Bremsungen übernommen werden, um bei einer externen Vorgabe einer Fahrzeug-Soll-Beschleunigung aSoll eine möglichst exakte Reaktion des Fahrzeuges 3 zu erhalten. Um die Genauigkeit der Bestimmung des Gesamtschaltdauer-Istwertes PIst weiter zu verbessern, können auch mehr als zwei Testbremsungen mit derselben Test-Fahrzeug-Beschleunigung aTest und unterschiedlicher Anzahl C1, C2, ... an Ansteuerpulsen A bzw. Nicht-Ansteuerpulsen NA durchgeführt werden.

Es können auch mehrere Einlernvorgänge hintereinander ausgeführt werden, d.h. nach Durchführung von mindestens zwei Testbremsungen können die aus diesen Testbremsungen erhaltenen Schaltparameter tE, tA, P als Schaltparameter-Ausgangswerte tE0, tA0, P0 für einen weiteren Einlernvorgang verwendet werden, um beispielsweise die Messung zu verifizieren oder die Schaltparameter-Ausgangswerte tE0, tA0. P0 an geänderte Umgebungsbedingungen, z. B. eine geänderte Umgebungstemperatur, anzupassen.

Ein Einlernvorgang mit der entsprechenden Anzahl an Testbremsungen sollte während der Fahrt mit einer Mindestgeschwindigkeit von 40 km/h erfolgen. Sollte während einer Testbremsung bzw. eines Einlernvorganges eine sicherheitskritische Anforderung für eine Bremsung bei der Steuereinrichtung 7 eingehen, kann der Einlernvorgang auch jederzeit übersteuert bzw. abgebrochen werden, um die Sicherheit nicht zu gefährden.

Weiterhin kann bei der Auswahl der Schaltparameter-Ausgangswerte tE0, tA0, P0 ein Alterungswert mitgeführt werden, der die verschleißabhängige Veränderung des jeweiligen Magnetsteuerventils 9a, 9b, 10a, 10b berücksichtigt und damit ein Einlernen von Schaltparametern tE, tA, P auch über die gesamte Lebensdauer des jeweiligen Magnetsteuerventils 9a, 9b, 10a, 10b ermöglicht.

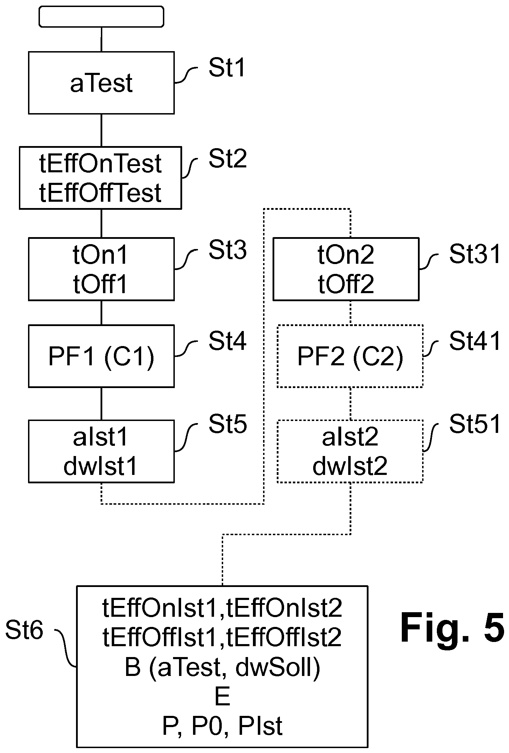

Gemäß Fig. 5 kann das erfindungsgemäße Verfahren wie folgt durchgeführt werden:

In einem anfänglichen Schritt St0 wird das Verfahren gestartet, beispielsweise mit dem Starten des Fahrzeuges 3 oder aber dem Erfassen einer extern angeforderten Bremsung über das XBR-Signal SXBR.

In einem ersten Schritt St1 wird eine Fahrzeug-Test-Beschleunigung aTest festgelegt, mit der die Testbremsungen durchgeführt werden sollen. Für diese Fahrzeug-Test-Beschleunigung aTest wird anschließend in einem zweiten Schritt St2 eine effektive Test-Aktivierungsdauer tEffOnTest oder eine effektive Test-Deaktivierungsdauer tEffOffTest ermittelt, je nachdem, ob die Testbremsungen durch ein Einlassventil 9a, 9b oder ein Auslassventil 10a, 10b bewirkt werden sollen, wobei die jeweilige effektive Test-Dauer tEffOnTest, tEffOffTest die Zeitdauer angibt, während der das jeweilige Magnetsteuerventil 9a, 9b, 10a, 10b in seiner aktivierten bzw. deaktivierten Stellung zu verbleiben hat, damit ein zu der Fahrzeug-Test-Beschleunigung aTest führender Bremsdruck pBa, pBb im entsprechenden Bremszylinder 4a, 4b ausgesteuert wird.

In einem dritten Schritt St3 wird aus der effektiven Test-Aktivierungsdauer tEffOnTest bzw. der effektiven Test-Deaktivierungsdauer tEffOffTest sowie mit den Schaltparameter-Ausgangswerten tE0, tA0, P des betreffenden Magnetsteuerventils 9a, 9b die erste Test-Pulsdauer tOn1 bzw. erste Pausendauer tOff1 ermittelt und in einem vierten Schritt St4 nach Festlegung der ersten Anzahl C1 an Ansteuerpulsen A bzw. Nicht-Ansteuerpulsen NA über das Steuersignal Sa, Sb eine entsprechende erste Test-Pulsfolge PF1 wie oben beschrieben an den oder die betreffenden Modulatoren 8a, 8b ausgegeben, wobei das jeweilige Magnetsteuerventil 9a, 9b, 10a, 10b über die erste Test-Pulsfolge PF1 mit der ersten Anzahl C1 an Ansteuerpulsen A über jeweils die erste Test-Pulsdauer tOn1 angesteuert wird oder mit der ersten Anzahl C1 an Nicht-Ansteuerpulsen NA über jeweils die erste Test-Pausenzeit tOff1 zwischen zwei Ansteuerpulsen A nicht angesteuert bzw. aktiviert wird, um die Testbremsung zu bewirken. In einem fünften Schritt St5 wird die Reaktion des Fahrzeuges 3 auf die Testbremsung ermittelt, indem die erste Fahrdynamik-Änderungsgröße aIst1, dwIst1 erfasst wird.

In Abhängigkeit der ersten Fahrdynamik-Änderungsgröße aIst1, dwIst1 wird dann in einem sechsten Schritt St6 wie oben beschrieben ausgewertet, ob eine Anpassung der Schaltparameter tE, tA, P nötig ist. Dazu wird gleichzeitig auf eine zweite Fahrdynamik-Änderungsgröße aIst2, dwIst2 aus einer zweiten Testbremsung an demselben Rad 6a, 6b zurückgegriffen. Die zweite Testbremsung mit der zweiten Test-Pulsfolge PF2, die eine zweite Anzahl C2 an Ansteuerpulsen A bzw. Nicht-Ansteuerpulsen NA aufweist und die zeitlich versetzt zur ersten Testbremsung sattfindet, ist in Fig. 5 gestrichelt in den Schritten St31, S41, St42 angedeutet. Die Ermittlung der entsprechenden Zeiten und Parameter für die zweite Testbremsung PF1 kann analog und parallel zur Ermittlung der Zeiten und Parameter für die erste Testbremsung PF2 stattfinden, die zweite Testbremsung PF2 wird allerdings zeitlich versetzt dazu ausgeführt.

Zur Bewertung im sechsten Schritt St6 kann hierbei jeweils ein Vergleich mit zu erwartenden Werten aTest, dwSoll unter Einbeziehung des Toleranzbandes B sowie des Schwellenwertes E stattfinden. Die Anpassung findet hierbei durch Ermitteln der Gesamtschaltdauer P über den Gesamtschaltdauer-Istwert PIst durch eine Differenzbildung für die beiden Testbremsungen wie oben beschrieben statt.

Bezugszeichenliste (Teil der Beschreibung)

| | |
|---|---|
| 1 | Bremssystem |
| 2 | Hinterachse |
| 3 | Fahrzeug |
| 4a, b | Bremszylinder |
| 5a, b | Betriebsbremse |
| 6a, b | Räder |
| 7 | Steuereinrichtung |
| 8a, 8b | Modulator |
| 9a, 9b | Einlassventil |
| 10a, 10b | Auslassventil |
| 11 | Druckmittelvorrat |
| 12a, 12b | Entlüftungsanschluss |
| 13a, 13b | Drehzahlsensor |
| 14 | Längsbeschleunigungssensor |
| | |
| aTest | Fahrzeug-Test-Beschleunigung |
| aIst | Fahrzeug-Ist-Beschleunigung |

| alst1 | erste Fahrzeug-Ist-Beschleunigung |
|---|---|
| alst2 | zweite Fahrzeug-Ist-Beschleunigung |
| aSoll | Fahrzeug-Soll-Beschleunigung |
| A | Ansteuerpuls |
| B | Toleranzband |
| C1 | erste Anzahl an Ansteuerpulsen |
| C2 | zweite Anzahl an Ansteuerpulsen |
| dwlst | Drehzahl-Ist-Änderung |
| dwlst1 | erste Drehzahl-Ist-Änderung |
| dwlst2 | zweite Drehzahl-Ist-Änderung |
| dwSoll | Drehzahl-Soll-Änderung |
| dwSoll | Drehzahl-Soll-Änderung |
| E | Schwellenwert |
| FEnv | Einflussfaktor |
| NA | Nicht-Ansteuerpuls |
| P0 | Gesamtschaltdauer-Ausgangswert |
| p11 | Vorratsdruck |
| P | Gesamtschaltdauer |
| pBa, pBb | Bremsdruck |
| PF1 | erste Test-Pulsfolge |
| PF2 | zweite Test-Pulsfolge |
| PIst | Gesamtschaltdauer-Istwert |
| Sa, Sb | Steuersignal |
| SDa, SDb | Drehzahlsensor-Signal |
| SXBR | XBR-Signal |
| tEffOn | effektive Aktivierungsdauer |
| tEffOnTest | effektive Test-Aktivierungsdauer |
| tEffOnIst1 | erste effektive Ist-Aktivierungsdauer |
| tEffOnIst2 | zweite effektive Ist-Aktivierungsdauer |
| tEffOff | effektive Deaktivierungsdauer |
| tEffOffTest | effektive Test-Deaktivierungsdauer |
| tEffOffIstI | erste effektive Ist-Deaktivierungsdauer |
| tEffOffIst2 | zweite effektive Ist-Deaktivierungsdauer |
| tE | Einschaltdauer |
| tE0 | Einschaltdauer-Ausgangswert |
| tEIst | Einschaltdauer-Istwert |
| tA | Abschaltdauer |
| tA0 | Abschaltdauer-Ausgangswert |
| tAIst | Abschaltdauer-Istwert |
| tOff | Pausendauer |
| tOff1 | erste Test-Pausendauer |
| tOff2 | zweite Test-Pausendauer |
| tOn | Pulsdauer |
| tOn1 | erste Test-Pulsdauer |
| tOn2 | zweite Test-Pulsdauer |
| w | Drehzahl |
| w1 | erste Drehzahl |
| w2 | zweite Drehzahl |

**Patentansprüche**

1.  Verfahren zum Einlernen von Schaltparametern (tE, tA, P) eines Magnetsteuerventils (9a, 9b, 10a, 10b) in einem Bremssystem (1) eines Fahrzeuges (3), insbesondere Nutzfahrzeuges, mit mindestens den folgenden Schritten:

      - Festlegen einer Fahrzeug-Test-Beschleunigung (aTest) (St1);
      - Ermitteln von mindestens zwei Test-Pulsfolgen (PF1, PF2), wobei die Test-Pulsfolgen (PF1, PF2) jeweils in Abhängigkeit der festgelegten Fahrzeug-Test-Beschleunigung (aTest) sowie in Abhängigkeit von Schaltparameter-Ausgangswerten (tEO, tA0, P0) für das jeweilige Magnetsteuerventil (9a, 9b, 10a, 10b) ermittelt werden und die Test-Pulsfolgen (PF1, PF2) Ansteuerpulse (A) und daran angrenzende Nicht-Ansteuerpulse (NA) aufweisen, wobei während eines Ansteuerpulses (A) eine Aktivierung des jeweiligen Magnetsteuerventils (9a, 9b, 10a, 10b) und während eines Nicht-Ansteuerpulses (NA) eine Deaktivierung des jeweiligen Magnetsteuerventils (9a, 9b, 10a, 10b) stattfindet (St2, St3),
- Ansteuern des jeweiligen Magnetsteuerventils (9a, 9b, 10a, 10b) mit den mindestens zwei Test-Pulsfolgen (PF1, PF2) zum Bewirken von mindestens zwei Testbremsungen, wobei durch die jeweilige Test-Pulsfolge (PF1, PF2) eine Veränderung eines Bremsdruckes (pBa, pBb) an einer Betriebsbremse (5a, 5b) des Bremssystems (1) derartig bewirkt wird, dass sich eine Änderung der Fahrdynamik (w, w1, w2) des Fahrzeuges (3) ergibt (St4, St41),
- Ermitteln von Fahrdynamik-Änderungsgrößen (aIst, aIst1, aIst2, dwIst, dwIst1, dwIst2) zum Erfassen der Änderung der Fahrdynamik (w1, w2) des Fahrzeuges (3) infolge der Ansteuerung mit der jeweiligen Test-Pulsfolge (PF1, PF2) (St5, St51), und
- Anpassen der Schaltparameter-Ausgangswerte (tEO, tA0, P0) für das Magnetsteuerventil (9a, 9b, 10a, 10b) in Abhängigkeit der Fahrdynamik-Änderungsgrößen (aIst, aIst1, aIst2, dwIst, dwIst1, dwIst2) zum Einlernen der Schaltparameter (tE, tA, P) des Magnetsteuerventils (9a, 9b, 10a, 10b) (St6).

2.  Verfahren nach Anspruch 1, **dadurch gekennzeichnet, dass** zum Ermitteln der Test-Pulsfolgen (PF1, PF2) für die Ansteuerpulse (A) eine Test-Pulsdauer (tOn1, tOn2) und/oder für die Nicht-Ansteuerpulse (NA) eine Test-Pausendauer (tOff1, tOff2) ermittelt wird, wobei

    - die Test-Pulsdauer (tOn1, tOn2) in Abhängigkeit einer Anzahl (C1, C2) an Ansteuerpulsen (A) pro Test-Pulsfolge (PF1, PF2) sowie in Abhängigkeit der jeweils festgelegten Fahrzeug-Test-Beschleunigung (aTest) und der Schaltparameter-Ausgangswerte (tEO, tA0, P0) ermittelt wird und/oder
    - die Test-Pausendauer (tOff1, tOff2) in Abhängigkeit einer Anzahl (C1, C2) an Nicht-Ansteuerpulsen (NA) pro Test-Pulsfolge (PF1, PF2) sowie in Abhängigkeit der jeweils festgelegten Fahrzeug-Test-Beschleunigung (aTest) und der Schaltparameter-Ausgangswerte (tEO, tA0, P0) ermittelt wird,
    wobei sich die Test-Pulsfolgen (PF1, PF2) zusammensetzen
    - aus der jeweiligen Anzahl (C1, C2) an Ansteuerpulsen (A), die die für die jeweilige Test-Pulsfolge (PF1, PF2) berechnete Test-Pulsdauer (tOn1, tOn2) aufweisen, und/oder
    - aus der jeweiligen Anzahl (C1, C2) an Nicht-Ansteuerpulsen (NA), die die für die jeweilige Test-Pulsfolge (PF1, PF2) berechnete Test-Pausendauer (tOff1, tOff2) aufweisen.

3.  Verfahren nach Anspruch 2, **dadurch gekennzeichnet, dass** die Test-Pulsdauer (tOn1, tOn2) für die jeweilige Test-Pulsfolge (PF1, PF2) ermittelt wird in Abhängigkeit einer effektiven Test-Aktivierungsdauer (tEffOnTest), wobei die effektive Test-Aktivierungsdauer (tEffOnTest) die Zeitdauer angibt, die das Magnetsteuerventil (9a, 9b, 10a, 10b) in seine aktivierte Stellung zu überführen ist, um eine Veränderung des Bremsdruckes (pBa, pBb) an der Betriebsbremse (5a, 5b) derartig zu bewirken, dass die festgelegte Fahrzeug-Test-Beschleunigung (aTest) für diese Test-Pulsfolge (PF1, PF2) umgesetzt wird.

4.  Verfahren nach Anspruch 2 oder 3, **dadurch gekennzeichnet, dass** die Test-Pausendauer (tOff1, tOff2) für die jeweiligen Test-Pulsfolgen (PF1, PF2) ermittelt wird in Abhängigkeit einer effektiven Test-Deaktivierungsdauer (tEffOffTest), wobei die effektive Test-Deaktivierungsdauer (tEffOffTest) die Zeitdauer angibt, die das Magnetsteuerventil (9a, 9b, 10a, 10b) in seine deaktivierte Stellung zu überführen ist, um eine Veränderung des Bremsdruckes (pBa, pBb) an der Betriebsbremse (5a, 5b) derartig zu bewirken, dass die festgelegte Fahrzeug-Test-Beschleunigung (aTest) für diese Test-Pulsfolge (PF1, PF2) umgesetzt wird.

5.  Verfahren nach Anspruch 3 oder 4, **dadurch gekennzeichnet, dass** die effektive Test-Aktivierungsdauer (tEffOnTest) und/oder die effektive Test-Deaktivierungsdauer (tEffOffTest) in Abhängigkeit eines Ansprechdruckes der jeweiligen Betriebsbremse (5a, 5b) ermittelt wird, wobei die effektive Test-Aktivierungsdauer (tEffOnTest) und/oder die effektive Test-Deaktivierungsdauer (tEffOffTest) für die festgelegte Fahrzeug-Test-Beschleunigung (aTest) aus einer Kennlinie folgt.

6.  Verfahren nach einem der Ansprüche 3 bis 5, **dadurch gekennzeichnet, dass**

    - die Test-Pulsdauer (tOn1, tOn2) für die jeweilige Test-Pulsfolge (PF1, PF2) aus der Summe der effektiven Test-Aktivierungsdauer (tEffOnTest) aufgeteilt auf die jeweilige Anzahl (C1, C2) an Ansteuerpulsen (A) der jeweiligen Test-Pulsfolge (PF1, PF2) und den Schaltparameter-Ausgangswerten (tEO, tA0, P0) folgt, und/oder

- die Test-Pausendauer (tOff1, tOff2) aus der Summe der effektiven Test-Deaktivierungsdauer (tEffOffTest) aufgeteilt auf die jeweilige Anzahl (C1, C2) an Nicht-Ansteuerpulsen (NA) der jeweiligen Test-Pulsfolge (PF1, PF2) und den Schaltparameter-Ausgangswerten (tEO, tA0, P0) folgt.

7. Verfahren nach einem der vorhergehenden Ansprüche, **dadurch gekennzeichnet, dass** ein Anpassen der Schaltparameter-Ausgangswerte (tEO, tA0, P0) lediglich dann stattfindet, wenn mindestens eine der Fahrdynamik-Änderungsgrößen (aIst1, aIst2, dwIst1, dwIst2) außerhalb eines Toleranzbandes (B) um einen erwarteten Wert (aTest, dwSoll) für die jeweilige Fahrdynamik-Änderungsgröße (aIst1, aIst2, dwIst1, dwIst2) liegt.

8. Verfahren nach einem der vorhergehenden Ansprüche, **dadurch gekennzeichnet, dass** als Schaltparameter-Ausgangswerte (tEO, tA0, P0) produktionsbedingte Schätzwerte oder vorab eingelernte Schaltparameter (tE, tA, P) für das Magnetsteuerventil (9a, 9b, 10a, 10b) verwendet werden.

9. Verfahren nach einem der vorhergehenden Ansprüche, **dadurch gekennzeichnet, dass** als Fahrdynamik-Änderungsgröße (aIst1, aIst2, dwIst1, dwIst2) lediglich die Änderung der Fahrdynamik (w1, w2) betrachtet wird, die in Reaktion auf das Ansteuern des Magnetsteuerventils (9a, 9b, 10a, 10b) mit der jeweiligen Test-Pulsfolge (PF1, PF2) erfolgt.

10. Verfahren nach einem der vorhergehenden Ansprüche, **dadurch gekennzeichnet, dass**

- als Schaltparameter eine Einschaltdauer (tE) und eine Abschaltdauer (tA) oder eine Gesamtschaltdauer (P), die aus einer Differenz aus Einschaltdauer (tE) und Abschaltdauer (tA) folgt, verwendet werden und
- zum Ermitteln der Test-Pulsfolge (PF1, PF2) als Schaltparameter-Ausgangswerte ein Einschaltdauer-Ausgangswert (tE0) und ein Abschaltdauer-Ausgangswert (tA0) oder ein Gesamtschaltdauer-Ausgangswert (P0), der aus einer Differenz aus Einschaltdauer-Ausgangswert (tE0) und Abschaltdauer-Ausgangswert (tA0) folgt, verwendet werden.

11. Verfahren nach einem der vorhergehenden Ansprüche, **dadurch gekennzeichnet, dass** eine erste Test-Pulsfolge (PF1) aus einer ersten Anzahl (C1) an Ansteuerpulsen (A) oder Nicht-Ansteuerpulsen (NA) zur Durchführung einer ersten Testbremsung und eine zweite Test-Pulsfolge (PF2) aus einer zweiten Anzahl (C2) an Ansteuerpulsen (A) oder Nicht-Ansteuerpulsen (NA) zur Durchführung einer zweiten Testbremsung ermittelt werden, wobei für beide Test-Pulsfolgen (PF1, PF2) die gleiche Fahrzeug-Test-Beschleunigung (aTest) festgelegt wird.

12. Verfahren nach Anspruch 11, **dadurch gekennzeichnet, dass** die erste Anzahl (C1) ungleich der zweiten Anzahl (C2) ist.

13. Verfahren nach Anspruch 11 oder 12, **dadurch gekennzeichnet, dass** die mindestens zwei Test-Pulsfolgen (PF1, PF2) zeitlich versetzt zueinander radweise an dasselbe Magnetsteuerventil (9a, 9b, 10a, 10b) oder achsweise an dieselben Magnetsteuerventile (9a, 9b, 10a, 10b) ausgesteuert werden.

14. Verfahren nach einem der Ansprüche 11 bis 13, **dadurch gekennzeichnet, dass** ein Anpassen der Schaltparameter-Ausgangswerte (tEO, tA0, P0) lediglich dann stattfindet, wenn eine erste Fahrdynamik-Änderungsgröße (aIst1, dwIst1), die sich aus der ersten Testbremsung ergibt, um mehr als einen Schwellenwert (E) von einer zweiten Fahrdynamik-Änderungsgröße (aIst2, dwIst2), die sich aus der zweiten Testbremsung ergibt, abweicht.

15. Verfahren nach einem der Ansprüche 11 bis 14, **dadurch gekennzeichnet, dass** der Schaltparameter-Ausgangswert (tEO, tA0, P0) in Abhängigkeit

- einer Differenz aus den ermittelten Fahrdynamik-Änderungsgrößen (aIst1, aIst2, dwIst1,dwIst2) und/oder
- einer Differenz aus ermittelten effektiven Ist-Aktivierungsdauern (tEffOnIst1, tEffOnIst2) und in Abhängigkeit des Unterschieds in der Anzahl (C1, C2) an Ansteuerpulsen (A) für die erste und die zweite Test-Pulsfolge (PF1, PF2) und/oder
- einer Differenz aus ermittelten effektiven Ist-Deaktivierungsdauern (tEffOffIst1, tEffOffIst2) und in Abhängigkeit des Unterschieds in der Anzahl (C1, C2) an Nicht-Ansteuerpulsen (NA) für die erste und die zweite Test-Pulsfolge (PF1, PF2) angepasst wird,
wobei die effektiven Ist-Aktivierungsdauern (tEffOnIst1, tEffOnIst2) und/oder Ist-Deaktivierungsdauern (tEffOffIst1, tEffOffIst2) aus den ermittelten Fahrdynamik-Änderungsgrößen (aIst1, aIst2, dwIst1, dwIst2) der jeweiligen Test-Pulsfolge (PF1, PF2) ermittelt werden und jeweils die Zeitdauer angeben, die das Magnetsteuerventil (9a, 9b, 10a, 10b) tatsächlich in seine aktivierte bzw. deaktivierte Stellung überführt wird, um die jeweilige ermittelte Fahrdynamik-Änderungsgröße (aIst1, aIst2, dwIst1, dwIst2) zu bewirken.

16. Verfahren nach einem der vorhergehenden Ansprüche, **dadurch gekennzeichnet, dass** bei der Ermittlung der jeweiligen Test-Pulsfolge (PF1, PF2) berücksichtigt wird, welcher Bremsdruck (pBa, pBb) an den Betriebsbremsen (5a, 5b) vor dem Ansteuern des jeweiligen Magnetsteuerventils (9a, 9b, 10a, 10b) mit der jeweiligen Test-Pulsfolge (PF1, PF2) bereits anliegt.

17. Verfahren nach einem der Ansprüche 1 bis 15, **dadurch gekennzeichnet, dass** das Einlernen des Schaltparameters (tE, tA, P) über die Fahrdynamik-Änderungsgröße (aIst1, aIst2, dwIst1, dwIst2) ohne Rückgriff auf den über einen Drucksensor gemessenen Bremsdruck (pBa, pBb) erfolgt.

18. Verfahren nach einem der vorhergehenden Ansprüche, **dadurch gekennzeichnet, dass** der Bremsdruck (pBa, pBb) in dem Bremszylinder (4a, 4b) der jeweiligen Betriebsbremse (5a, 5b) vor dem Ansteuern des jeweiligen Magnetsteuerventils (9a, 9b, 10a, 10b) mit der jeweiligen Test-Pulsfolge (PF1, PF2) auf einen vordefinierten Wert eingestellt wird und/oder die Bremszylinder (4a, 4b) der jeweiligen Betriebsbremse (5a, 5b) entlüftet werden.

19. Verfahren nach einem der vorhergehenden Ansprüche, **dadurch gekennzeichnet, dass** die Fahrdynamik-Änderungsgröße (aIst1, aIst2, dwIst1, dwIst2) über einen Drehzahlsensor (13a, 13b) und/oder über einen Längsbeschleunigungssensor (14) erfasst wird, wobei als Fahrdynamik-Änderungsgröße eine Drehzahl-Ist-Änderung (dwIst1, dwIst2) oder eine Fahrzeug-Ist-Beschleunigung (aIst1, aIst2) verwendet wird und diese mit einem erwarteten Wert (aTest, dwSoll) verglichen werden können, wobei der erwartete Wert die festgelegte Fahrzeug-Test-Beschleunigung (aTest) und/oder eine daraus folgende Drehzahl-Soll-Änderung (dwSoll) der Räder (6a, 6b) ist.

20. Verfahren nach Anspruch 19, **dadurch gekennzeichnet, dass** eine über den Drehzahlsensor (13a, 13b) ermittelte Fahrdynamik-Änderungsgröße (aIst1, aIst2, dwIst1,dwIst2) mit einer über den Längsbeschleunigungssensor (14) erfassten Fahrdynamik-Änderungsgröße (aIst1, aIst2, dwIst1, dwIst2) verglichen wird zum Plausibilisieren der ermittelten Fahrzeugdynamik-Änderungsgröße (aIst1, aIst2, dwIst1, dwIst2).

21. Verfahren nach einem der vorhergehenden Ansprüche, **dadurch gekennzeichnet, dass** die Schaltparameter (tE, tA, P) für ein als Magnetsteuerventil ausgebildetes Einlassventil (9a, 9b) und/oder für ein als Magnetsteuerventil ausgebildetes Auslassventil (10a, 10b) eingelernt werden, wobei

  - das Einlassventil (9a, 9b) während einer Ansteuerung mit einer Anzahl (C1, C2) an Ansteuerpulsen (A) infolge eine Aktivierung in seine geöffnete Stellung übergeht, in der eine Änderung der Fahrdynamik (w, w1, w2) durch ein Erhöhen des Bremsdruckes (pBa, pBb) bewirkt werden kann, wenn das Auslassventil (10a, 10b) gleichzeitig in seine geschlossene Stellung überführt ist, und
  - das Auslassventil (10a, 10b) während einer Nicht-Ansteuerung mit einer Anzahl (C1, C2) an Nicht-Ansteuerpulsen (NA) infolge eine Deaktivierung in seine geöffnete Stellung übergeht, in der eine Änderung der Fahrdynamik (w, w1, w2) durch ein Reduzieren des Bremsdruckes (pBa, pBb) bewirkt werden kann, wenn das Einlassventil (9a, 9b) gleichzeitig in seine geschlossene Stellung überführt ist.

22. Bremssystem (1), insbesondere elektropneumatisches Bremssystem (1), für ein Fahrzeug (3), insbesondere Nutzfahrzeug, geeignet zur Durchführung des Verfahrens nach einem der vorhergehenden Ansprüche, mit Betriebsbremsen (5a, 5b), den Betriebsbremsen (5a, 5b) vorgeschaltete Modulatoren (8a, 8b) zum Aussteuern eines Bremsdruckes (pBa, pBb) an Bremszylinder (4a, 4b) der Betriebsbremsen (5a, 5b) durch elektrisches Ansteuern von Magnetsteuerventilen (9a, 9b, 10a, 10b) in den jeweiligen Modulatoren (8a, 8b) über Steuersignale (Sa, Sb), wobei die Steuersignale (Sa, Sb) von einer Steuereinrichtung (7) ausgegeben werden, wobei die Steuereinrichtung (7) ausgebildet ist, mindestens zwei Test-Pulsfolgen (PF1, PF2) zur Durchführung von mindestens zwei Testbremsung zu ermitteln und an die Magnetsteuerventile (9a, 9b, 10a, 10b) auszusteuern, sowie in Abhängigkeit einer Änderung der Fahrdynamik (w1, w2) infolge der Testbremsungen Schaltparameter (tE, tA, P) der Magnetsteuerventile (9a, 9b, 10a, 10b) zu ermitteln und einzulernen.

23. Bremssystem (1) nach Anspruch 22, **dadurch gekennzeichnet, dass** die Steuereinrichtung (7) ausgebildet ist, die Magnetsteuerventile (9a, 9b, 10a, 10b) radindividuell oder achsindividuell oder seitenindividuell anzusteuern.

24. Bremssystem (1) nach Anspruch 22 oder 23, **dadurch gekennzeichnet, dass** die Steuereinrichtung (7) ausgebildet ist, die Schaltparameter (tE, tA, P) ohne Rückgriff auf einen Drucksensor zu ermitteln.

**25.** Bremssystem (1) nach einem der Ansprüche 22 bis 24, **dadurch gekennzeichnet, dass** die Magnetsteuerventile in dem Modulator (8a, 8b) als Einlassventile (9a, 9b) zum Erhöhen des Bremsdruckes (pBa, pBb) an der jeweiligen Betriebsbremse (5a, 5b) und als Auslassventile (10a, 10b) zum Reduzieren des Bremsdruckes (pBa, pBb) an der jeweiligen Betriebsbremse (5a, 5b) ausgeführt sind,

wobei die Einlassventile (9a, 9b) infolge einer Ansteuerung mit einem Ansteuerpuls (A) in ihre geöffnete Stellung übergehen zum Erhöhen des Bremsdruckes (pBa, pBb) bei gleichzeitig geschlossenem Auslassventil (10a, 10b) und die Auslassventile (10a, 10b) infolge einer Nicht-Ansteuerung mit einem Nicht-Ansteuerpuls (NA) in ihre geöffnete Stellung übergehen zum Reduzieren des Bremsdruckes (pBa, pBb) bei gleichzeitig geschlossenem Einlassventil (9a, 9b).

**Claims**

**1.** A method for teaching switching parameters (tE, tA, P) of a solenoid control valve (9a, 9b, 10a, 10b) in a braking system (1) of a vehicle (3), in particular of a commercial vehicle, having at least the following steps:

- defining a vehicle test acceleration (aTest) (St1);
- determining at least two test pulse sequences (PF1, PF2), wherein each test pulse sequence (PF1, PF2) is determined in accordance with the defined vehicle test acceleration (aTest) and in accordance with the switching parameter initial values (tEO, tA0, P0) for the solenoid control valve (9a, 9b, 10a, 10b) in question and the test pulse sequences (PF1, PF2) comprising actuation pulses (A) and adjacent non-actuation pulses (NA), wherein during an actuation pulse (A) an activation of the respective solenoid control valve (9a, 9b, 10a, 10b) takes place and during a non-actuation pulse (NA) a deactivation of the respective solenoid control valve (9a, 9b, 10a, 10b) takes place (St2, St3);
- controlling the solenoid control valve (9a, 9b, 10a, 10b) by means of the at least two test pulse sequences (PF1, PF2) in order to effect at least two braking operations, a change in a brake pressure (pBa, pBb) at a service brake (5a, 5b) of the braking system (1) being effected by each test pulse sequence (PF1, PF2) in such a way that a change in the driving dynamics (w, w1, w2) of the vehicle (3) results (St4, St41) ;
- determining driving dynamics change variables (aIst, aIst1, aIst2, dwIst, dwIst1, dwIst2) in order to determine the change in the driving dynamics (w1, w2) of the vehicle (3) resulting from the control with the corresponding test pulse sequence (PF1, PF2) (St5, St51), and
- adjusting the switching-parameter initial values (tEO, tA0, P0) for the solenoid control valve (9a, 9b, 10a, 10b) in accordance with the driving-dynamics change variables (aIst, aIst1, aIst2, dwIst, dwIst1, dwIst2) in order to teach the switching parameters (tE, tA, P) of the solenoid control valve (9a, 9b, 10a, 10b) (St6).

**2.** The method according to claim 1, **characterized in that** for determining the test pulse sequences (PF1, PF2) for the actuation pulses (A) a test pulse duration (tOn1, tOn2) is determined and/or for the non-actuation pulses (NA) a test pause duration (tOff1, tOff2) is determined, wherein

- the test pulse duration (tOn1, tOn2) is determined depending on a number (C1, C2) of actuation pulses (A) per test pulse sequence (PF1, PF2) as well as on the respectively determined vehicle test acceleration (aTest) and the switching parameter output values (tEO, tA0, P0) and/or
- the test pause duration (tOff1, tOff2) is determined as a function of a number (C1, C2) of non-actuation pulses (NA) per test pulse sequence (PF1, PF2) as well as depending on the respectively determined vehicle test acceleration (aTest) and the switching parameter output values (tEO, tA0, P0),
wherein the test pulse sequences (PF1, PF2) are composed of
- the respective number (C1, C2) to actuation pulses (A), the test-pulse duration (tOn1, tOn2) calculated for the respective test pulse sequence (PF1, PF2), and/or
- the respective number (C1, C2) of non-actuation pulses (NA), which have the test pause duration (tOff1, tOff2) calculated for the respective test pulse sequence (PF1, PF2),

**3.** The method according to claim 2, **characterized in that** the test pulse duration (tOn1, tOn2) for the respective test pulse sequence (PF1, PF2) is determined as a function of an effective test activation duration (tEffOnTest), wherein the effective test activation duration (tEffOnTest) indicates the time duration **in that** the solenoid control valve (9a, 9b, 10a, 10b) is to be transferred to its activated position in order to effect a change of the brake pressure (pBa, pBb) on the service brake (5a, 5b) such that the predetermined vehicle test acceleration (aTest) for this test pulse sequence (PF1, PF2) is implemented.

4. The method according to claim 2 or 3, **characterized in that** the test pause duration (tOff1, tOff2) for the respective test pulse sequences (PF1, PF2) is determined as a function of an effective test deactivation duration (tEffOffTest), wherein the effective test deactivation duration (tEffOffTest) indicates the time duration **in that** the solenoid control valve (9a, 9b, 10a, 10b) is to be transferred to its deactivated position in order to effect a change of the brake pressure (pBa, pBb) on the service brake (5a, 5b) such that the predetermined vehicle test acceleration (aTest) for this test pulse sequence (PF1, PF2) is implemented.

5. The method according to claim 3 or 4, **characterized in that** the effective test activation duration (tEffOnTest) and/or the effective test deactivation duration (tEffOffTest) is determined as a function of a response pressure of the respective service brake (5a, 5b), wherein the effective test activation duration (tEffOnTest) and/or the effective test deactivation duration (tEffOffTest) for the specified vehicle test acceleration (aTest) ensues from a characteristic curve.

6. The method according to any of claims 3 to 5, **characterized in that**

   - the test pulse duration (tOn1, tOn2) for the respective test pulse sequence (PF1, PF2) ensues from the sum of the effective test activation time (tEffOnTest) divided into the respective number (C1, C2) of actuation pulses (A) follows the respective test pulse sequence (PF1, PF2) and the switching parameter output values (tEO, tA0, P0), and/or
   - the test pause duration (tOff1, tOff2) ensues from the sum of the effective test deactivation duration (tEffOffTest) divided into the respective number (C1, C2) of non-actuation pulses (NA) of the respective test pulse sequence (PF1, PF2) and the switching parameters Output values (tEO, tA0, P0).

7. The method according to any of the preceding claims, **characterized in that** an adjustment of the switching parameter output values (tEO, tA0, P0) takes place only if at least one of the driving dynamics change variables (aIst1, aIst2, dwIst1, dwIst2) lies outside a tolerance range (B) by an expected value (aTest, dwSoll) for the respective driving dynamics change variable (aIst1, aIst2, dwIst1, dwIst2).

8. The method according to any of the preceding claims, **characterized in that** production-related estimated values or previously learned switching parameters (tE, tA, P) for the magnetic control valve (9a, 9b, 10a, 10b) are used as switching parameter output values (tEO, tA0, P0).

9. The method according to any of the preceding claims, **characterized in that** only the change of the driving dynamics (w1, w2) is considered as a vehicle dynamics change variable (aIst1, aIst2, dwIst1, dwIst2), which takes place in response to the activation of the solenoid control valve (9a, 9b, 10a, 10b) with the respective test pulse sequence (PF1, PF2).

10. The method according to any of the preceding claims, **characterized in that**

    - a duty cycle (tE) and a switched-off duration (tA) or a total duty cycle (P), which ensues from a difference between duty cycle (tE) and switch-off (tA), are used as switching parameters, and
    - a switch-on output value (tE0) and a switch-off duration output value (tA0) or a total switch-time output value (P0), which ensues from a difference between the switch-on output value (tE0) and switch-off duration output value (tA0) are used to determine the test pulse sequence (PF1, PF2) as switching parameter output values.

11. The method according to any of the preceding claims, **characterized in that** a first test pulse sequence (PF1) is determined from a first number (C1) of actuation pulses (A) or non-actuation pulses (NA) for carrying out a first test braking and a second test pulse sequence (PF2) is determined from a second number (C2) of actuation pulses (A) or non-actuation pulses (NA) for carrying out a second test braking, wherein the same vehicle test acceleration (aTest) is used for both test pulse sequences (PF1, PF2).

12. The method according to claim 11, **characterized in that** the first number (C1) is unequal to the second number (C2) .

13. The method according to claim 11 or 12, **characterized in that** the at least two test pulse sequences (PF1, PF2) are applied temporally offset to each other by wheels on the same solenoid control valve (9a, 9b, 10a, 10b) or by axles on the same solenoid control valve (9a, 9b, 10a, 10b).

14. The method according to any of claims 11 to 13, **characterized in that** an adjustment of the switching parameter output values (tE0, tA0, P0) takes place only if a first driving dynamics change variable (aIst1, dwIst1), which results from the first test braking, deviates by more than a threshold value (E) from a second vehicle dynamics change variable (aIst2, dwIst2) resulting from the second test braking.

15. The method according to any of claims 11 through 14, **characterized in that** the switching parameter output value (tE0, tA0, P0) is adjusted as a function of

- a difference from the determined driving dynamics change quantities (aIst1, aIst2, dwIst1, dwIst2) and/or
- a difference of determined effective actual activation periods (tEffOnIst1, tEffOnIst2) and depending on the difference in the number (C1, C2) of actuation pulses (A) for the first and the second test pulse sequence (PF1, PF2) and/or
- a difference between the determined actual effective deactivation durations (tEffOffIst1, tEffOffIst2) and is adjusted as a function of the difference in the number (C1, C2) of non-actuation pulses (NA) for the first and the second test pulse sequence (PF1, PF2),
wherein the effective actual activation durations (tEffOnIst1, tEffOnIst2) and/or actual deactivation periods (tEffOffIst1, tEffOffIst2) are determined from the determined driving dynamics change quantities (aIst1, aIst2, dwIst1, dwIst2) of the respective test pulse sequence (PF1, PF2) and in each case indicate the time duration which the solenoid control valve (9a, 9b, 10a, 10b) is actually transferred to its activated or deactivated position to effect the respective determined driving dynamics change variable (aIst1, aIst2, dwIst1, dwIst2).

16. The method according to any of the preceding claims, **characterized in that** in the determination of the respective test pulse sequence (PF1, PF2), it is taken into consideration which brake pressure (pBa, pBb) is already applied to the service brake (5a, 5b) before driving the respective solenoid control valve (9a, 9b, 10a, 10b) with the respective test pulse sequence (PF1, PF2).

17. The method according to any of claims 1 to 15, **characterized in that** the teaching of the switching parameter (tE, tA, P) takes place via the driving dynamics change variable (aIst1, aIst2, dwIst1, dwIst2) without resorting to the brake pressure (pBa, pBb) measured via a pressure sensor.

18. The method according to any of the preceding claims, **characterized in that** the brake pressure (pBa, pBb) in the brake cylinder (4a, 4b) of the respective service brake (5a, 5b) is set to a predefined value and/or the brake cylinders (4a, 4b) of the respective service brake (5a, 5b) are vented before driving the respective solenoid control valve (9a, 9b, 10a, 10b) with the respective test pulse sequence (PF1, PF2).

19. The method according to any of the preceding claims, **characterized in that** the driving dynamics change variable (aIst1, aIst2, dwIst1, dwIst2) is detected via a speed sensor (13a, 13b) and/or via a longitudinal acceleration sensor (14), wherein an actual speed change (dwIst1, dwIst2) or vehicle actual acceleration (aIst1, aIst2) is used as the driving dynamics change variable and these can be compared with an expected value (aTest, dwSoll), wherein the expected value is the specified vehicle test acceleration (aTest) and/or a consequent speed-desired change (dwSoll) of the wheels (6a, 6b) .

20. The method according to claim 19, **characterized in that** a vehicle dynamics change variable (aIst1, aIst2, dwIst1, dwIst2) determined via the speed sensor (13a, 13b) is compared with a vehicle dynamics change variable (aIst1, aIst2, dwIst1, dwIst2) detected via the longitudinal acceleration sensor (14) for plausibility checking of the determined vehicle dynamics change variable (aIst1, aIst2, dwIst1, dwIst2).

21. The method according to any of the preceding claims, **characterized in that** the switching parameters (tE, tA, P) are taught for an inlet valve designed as a solenoid control valve (9a, 9b) and/or are taught as an exhaust valve (10a, 10b) designed as a solenoid control valve, wherein

- the intake valve (9a, 9b) transitions to its open position during a drive with a number (C1, C2) of actuation pulses (A) as a result of activation, in which a change of the driving dynamics (w, w1, w2) can be effected by increasing the brake pressure (pBa, pBb) when the exhaust valve (10a, 10b) is simultaneously moved to its closed position, and
- the exhaust valve (10a, 10b) transitions to its open position during a non-actuation with a number (C1, C2) of non-actuation pulses (NA) due to a deactivation in which a change in the driving dynamics (w, w1, w2) can be effected by reducing the brake pressure (pBa, pBb) when the intake valve (9a, 9b) is simultaneously transferred to its closed position.

**22.** A braking system (1), in particular an electropneumatic braking system (1), for a vehicle (3), suitable for carrying out the method according to any of the preceding claims, with service brakes (5a, 5b), the modulators (8a, 8b) upstream of the service brakes (5a, 5b) for controlling a brake pressure (pBa, pBb) on brake cylinders (4a, 4b) of the service brakes (5a, 5b) by electrically driving solenoid control valves (9a, 9b, 10a, 10b) in the respective modulators (8a, 8b) via control signals (Sa, Sb), wherein the control signals (Sa, Sb) are output by a control device (7), wherein the control device (7) is designed to determine at least two test pulse sequences (PF1, PF2) for performing at least two test brakings and to apply the solenoid control valves (9a, 9b, 10a, 10b), and in response to a change in vehicle dynamics (w1, w2) due to the test braking to determine and teach switching parameters (tE, tA, P) of the solenoid control valves (9a, 9b, 10a, 10b).

**23.** The braking system (1) according to claim 22, **characterized in that** the control device (7) is configured to control the solenoid control valves (9a, 9b, 10a, 10b) on a wheel-individual or axle-individual or side-by-side basis.

**24.** The braking system (1) according to claim 22 or 23, **characterized in that** the control device (7) is configured to determine the switching parameters (tE, tA, P) without resorting to a pressure sensor.

**25.** The braking system (1) according to any of claims 22 to 24, **characterized in that** the solenoid control valves are designed in the modulator (8a, 8b) as intake valves (9a, 9b) to increase the brake pressure (pBa, pBb) and are designed as exhaust valves (10a, 10b) for reducing the brake pressure (pBa, pBb) on the respective service brake (5a, 5b),
wherein the intake valves (9a, 9b), due to a control with a control pulse (A), transition to their open position to increase the brake pressure (pBa, pBb) with a simultaneously closed exhaust valve (10a, 10b) and the exhaust valves (10a, 10b), due to a non-actuation with a non-actuation pulse (NA), transition to their open position to reduce the brake pressure (pBa, pBb) with a simultaneously closed intake valve (9a, 9b).

**Revendications**

**1.** Procédé d'acquisition de paramètres de commutation (tE, tA, P) d'une valve de commande magnétique (9a, 9b, 10a, 10b) dans un système de freinage (1) d'un véhicule (3), en particulier d'un véhicule utilitaire, avec au moins les étapes suivantes qui consistent à :

- établir une accélération de test de véhicule (aTest) (St1) ;
- déterminer au moins deux trains d'impulsions de test (PF1, PF2), dans lequel les trains d'impulsions de test (PF1, PF2) sont respectivement déterminés en fonction de l'accélération de test de véhicule (aTest) établie ainsi qu'en fonction de valeurs de sortie de paramètres de commutation (tEO, tA0, P0) pour la valve de commande magnétique (9a, 9b, 10a, 10b) respective et les trains d'impulsions de test (PF1, PF2) présentent des impulsions de commande (A) et des impulsions de non-commande (NA) contiguës à celles-ci, dans lequel une activation de la valve de commande magnétique (9a, 9b, 10a, 10b) respective a lieu pendant une impulsion de commande (A) et une désactivation de la valve de commande magnétique (9a, 9b, 10a, 10b) a lieu pendant une impulsion de non-commande (NA) (St2, St3),
- commander la valve de commande magnétique (9a, 9b, 10a, 10b) respective avec les au moins deux trains d'impulsions de test (PF1, PF2) pour obtenir au moins deux freinages de test, dans lequel une modification d'une pression de freinage (pBa, pBb) au niveau d'un frein de service (5a, 5b) du système de freinage (1) est obtenue par le train d'impulsions de test (PF1, PF2) respectif de telle sorte que se produise une modification de la dynamique de roulage (w, w1, w2) du véhicule (3) (St4, St41),
- déterminer des grandeurs de modification de dynamique de roulage (aIst, aIst1, aIst2, dwIst, dwIst1, dwIst2) pour saisir la modification de la dynamique de roulage (w1, w2) du véhicule (3) à la suite de la commande avec le train d'impulsions de test (PF1, PF2) respectif (St5, St51), et
- ajuster les valeurs de sortie de paramètres de commutation (tEO, tA0, P0) pour la valve de commande magnétique (9a, 9b, 10a, 10b) en fonction des grandeurs de modification de dynamique de roulage (aIst, aIst1, aIst2, dwIst, dwIst1, dwIst2) pour l'acquisition des paramètres de commutation (tE, tA, P) de la valve de commande magnétique (9a, 9b, 10a, 10b) (St6).

**2.** Procédé selon la revendication 1, **caractérisé en ce que** pour déterminer les trains d'impulsions de test (PF1, PF2) une durée d'impulsion de test (tOn1, tOn2) est déterminée pour les impulsions de commande (A) et/ou une durée de pause de test (tOff1, tOff2) est déterminée pour les impulsions de non-commande (NA), dans lequel

- la durée d'impulsion de test (tOn1, tOn2) est déterminée en fonction d'un nombre (C1, C2) d'impulsions de commande (A) par train d'impulsions de test (PF1, PF2), ainsi qu'en fonction de l'accélération de test de véhicule (aTest) respectivement établie et des valeurs de sortie de paramètres de commutation (tE0, tA0, P0) et/ou

- la durée de pause de test (tOff1, tOff2) est déterminée en fonction d'un nombre (C1, C2) d'impulsions de non-commande (NA) par train d'impulsions de test (PF1, PF2), ainsi qu'en fonction de l'accélération de test de véhicule (aTest) respectivement établie et des valeurs de sortie de paramètres de commutation (tE0, tA0, P0), dans lequel les trains d'impulsions de test (PF1, PF2) se composent

- du nombre (C1, C2) respectif d'impulsions de commande (A) qui présentent la durée d'impulsion de test (tOn1, tOn2) calculée pour le train d'impulsions de test (PF1, PF2) respectif, et/ou

- du nombre (C1, C2) respectif d'impulsions de non-commande (NA) qui présentent la durée de pause de test (tOff1, tOff2) calculée pour le train d'impulsions de test (PF1, PF2) respectif.

3.  Procédé selon la revendication 2, **caractérisé en ce que** la durée d'impulsion de test (tOn1, tOn2) pour le train d'impulsions de test (PF1, PF2) respectif est déterminée en fonction d'une durée d'activation de test effective (tEffOnTest), dans lequel la durée d'activation de test effective (tEffOnTest) donne la durée pendant laquelle la valve de commande magnétique (9a, 9b, 10a, 10b) doit être transférée jusque dans sa position activée afin d'obtenir une modification de la pression de freinage (pBa, pBb) au niveau du frein de service (5a, 5b) de sorte que l'accélération de test de véhicule (aTest) établie soit mise en œuvre pour ce train d'impulsions de test (PF1, PF2).

4.  Procédé selon la revendication 2 ou 3, **caractérisé en ce que** la durée de pause de test (tOff1, tOff2) pour les trains d'impulsions de test (PF1, PF2) respectifs est déterminée en fonction d'une durée de désactivation de test effective (tEffOffTest), dans lequel la durée de désactivation de test effective (tEffOffTest) donne la durée pendant laquelle la valve de commande magnétique (9a, 9b, 10a, 10b) doit être transférée jusque dans sa position désactivée afin d'obtenir une modification de la pression de freinage (pBa, pBb) au niveau du frein de service (5a, 5b) de sorte que l'accélération de test de véhicule (aTest) établie soit mise en œuvre pour ce train d'impulsions de test (PF1, PF2).

5.  Procédé selon la revendication 3 ou 4, **caractérisé en ce que** la durée d'activation de test effective (tEffOnTest) et/ou la durée de désactivation de test effective (tEffOffTest) est déterminée en fonction d'une pression de seuil du frein de service (5a, 5b) respectif, dans lequel la durée d'activation de test effective (tEffOnTest) et/ou la durée de désactivation de test effective (tEffOffTest) pour l'accélération de test de véhicule (aTest) découle d'une courbe caractéristique.

6.  Procédé selon l'une des revendications 3 à 5, **caractérisé en ce que**

- la durée d'impulsion de test (tOn1, tOn2) pour le train d'impulsions de test (PF1, PF2) respectif découle de la somme des durées d'activation de test effectives (tEffOnTest) réparties sur le nombre (C1, C2) respectif d'impulsions de commande (A) du train d'impulsions de test (PF1, PF2) respectif et des valeurs de sortie de paramètres de commutation (tE0, tA0, P0), et/ou

- la durée de pause de test (tOff1, tPOff2) découle de la somme des durées de désactivation de test effectives (tEffOffTest) réparties sur le nombre (C1, C2) respectif d'impulsions de non-commande (NA) du train d'impulsions de test (PF1, PF2) respectif et des valeurs de sortie de paramètres de commutation (tE0, tA0, P0).

7.  Procédé selon l'une des revendications précédentes, **caractérisé en ce qu'**un ajustement des valeurs de sortie de paramètres de commutation (tE0, tA0, P0) se produit uniquement lorsqu'au moins une des grandeurs de modification de dynamique de roulage (aIst1, aIst2, dwIst1, dwIst2) se situe à l'extérieur d'une plage de tolérance (B) pour une valeur attendue (aTest, dwSoll) pour la grandeur de modification de dynamique de roulage (aIst1, aIst2, dwIst1, dwIst2) respective.

8.  Procédé selon l'une des revendications précédentes, **caractérisé en ce qu'**en tant que valeurs de sortie de paramètres de commutation (tE0, tA0, P0) sont utilisées des valeurs d'estimation conditionnées par le produit ou des paramètres de commutation (tE, tA, P) pour la valve de commande magnétique (9a, 9b, 10a, 10b) acquis au préalable.

9.  Procédé selon l'une des revendications précédentes, **caractérisé en ce qu'**en tant que grandeur de modification de dynamique de roulage (aIst1, aIst2, dwIst1, dwIst2) est uniquement prise en considération la modification de la dynamique de roulage (w1, w2) qui s'opère en réaction à la commande de la valve de commande magnétique (9a, 9b, 10a, 10b) avec le train d'impulsions de test (PF1, PF2) respectif.

10. Procédé selon l'une des revendications précédentes, **caractérisé en ce que**

- sont utilisées, en tant que paramètres de commutation, une durée d'allumage de commutation (tE) et une durée d'extinction de commutation (tA) ou une durée de commutation totale (P) qui découle d'une différence entre durée d'allumage de commutation (tE) et durée d'extinction de commutation (tA), et

- pour déterminer le train d'impulsions de test (PF1, PF2) sont utilisées, en tant que valeurs de sortie de paramètres de commutation, une valeur de sortie de durée d'allumage de commutation (tE0) et une valeur de sortie de durée d'extinction de commutation (tA0) ou une valeur de sortie de durée de commutation totale (P0) qui découle d'une différence entre valeur de sortie de durée d'allumage de commutation (tE0) et valeur de sortie de durée d'extinction de commutation (tA0).

**11.** Procédé selon l'une des revendications précédentes, **caractérisé en ce que** sont déterminés un premier train d'impulsions de test (PF1) à partir d'un premier nombre (C1) d'impulsions de commande (A) ou d'impulsions de non-commande (NA) pour mettre en œuvre un premier freinage de test et un second train d'impulsions de test (PF2) à partir d'un second nombre (C2) d'impulsions de commande (A) ou d'impulsions de non-commande (NA) pour mettre en œuvre un second freinage de test,

dans lequel pour les deux trains d'impulsions de test (PF1, PF2) est établie la même accélération de test de véhicule (aTest).

**12.** Procédé selon la revendication 11, **caractérisé en ce que** le premier nombre (C1) est différent du second nombre (C2).

**13.** Procédé selon la revendication 11 ou 12, **caractérisé en ce que** les au moins deux trains d'impulsions de test (PF1, PF2) sont commandés de façon décalée dans le temps à la manière d'une roue au niveau de la même valve de commande magnétique (9a, 9b, 10a, 10b) ou à la manière d'un axe au niveau des mêmes valves de commande magnétique (9a, 9b, 10a, 10b) .

**14.** Procédé selon l'une des revendications 11 à 13, **caractérisé en ce qu'**un ajustement des valeurs de sortie de paramètres de commutation (tE0, tA0, P0) se produit uniquement lorsqu'une première grandeur de modification de dynamique de roulage (aIst1, dwIst1) qui résulte du premier freinage de test s'écarte de plus d'une valeur seuil (E) d'une seconde grandeur de modification de dynamique de roulage (aIst2, dwIst2) qui résulte du second freinage de test.

**15.** Procédé selon l'une des revendications 11 à 14, **caractérisé en ce que** la valeur de sortie de paramètres de commutation (tE0, tA0, P0) est ajustée en fonction de

- une différence entre les grandeurs de modification de dynamique de roulage (aIst1, aIst2, dwIst1, dwIst2) déterminées et/ou
- une différence entre des durées d'activation réelles effectives (tEffOnIst1, tEffOnIst2) déterminées et en fonction de la différence dans le nombre (C1, C2) d'impulsions de commande (A) pour le premier et le second train d'impulsions de test (PF1, PF2) et/ou
- une différence entre des durées de désactivation réelles effectives (tEffOffIst1, tEffOffIst2) déterminées et en fonction de la différence dans le nombre (C1, C2) d'impulsions de non-commande (NA) pour le premier et le second train d'impulsions de test (PF1, PF2),

dans lequel les durées d'activation réelles (tEffOnIst1, tEffOnIst2) et/ou les durées de désactivation réelles (tEffOffIst1, tEffOffIst2) effectives sont déterminées à partir des grandeurs de modification de dynamique de roulage (aIst1, aIst2, dwIst1, dwIst2) déterminées des trains d'impulsions de test (PF1, PF2) respectifs et donnent respectivement la durée pendant laquelle la valve de commande magnétique (9a, 9b, 10a, 10b) est effectivement transférée jusque dans sa position activée ou désactivée afin d'obtenir la grandeur de modification de dynamique de roulage (aIst1, aIst2, dwIst1, dwIst2) déterminée respective.

**16.** Procédé selon l'une des revendications précédentes, **caractérisé en ce que** lors de la détermination du train d'impulsions de test (PF1, PF2) respectif est tenu compte de la pression de freinage (pBa, pBb) au niveau des freins de service (5a, 5b) qui est déjà présente avant la commande de la valve de commande magnétique (9a, 9b, 10a, 10b) respective avec le train d'impulsions de test (PF1, PF2) respectif.

**17.** Procédé selon l'une des revendications 1 à 15, **caractérisé en ce que** l'acquisition du paramètre de commutation (tE, tA, P) s'opère via la grandeur de modification de dynamique de roulage (aIst1, aIst2, dwIst1, dwIst2) sans recours à la pression de freinage (pBa, pBb) mesurée via un capteur de pression.

**18.** Procédé selon l'une des revendications précédentes, **caractérisé en ce que** la pression de freinage (pBa, pBb) dans le cylindre de frein (4a, 4b) du frein de service (5a, 5b) respectif est réglée avant la commande de la valve de commande magnétique (9a, 9b, 10a, 10b) respective avec le train d'impulsions de test (PF1, PF2) respectif sur une valeur prédéfinie et/ou les cylindres de frein (4a, 4b) du frein de service (5a, 5b) respectif sont purgés.

**19.** Procédé selon l'une des revendications précédentes, **caractérisé en ce que** la grandeur de modification de dynamique de roulage (aIst1, aIst2, dwIst1, dwIst2) est saisie via un capteur de vitesse (13a, 13b) et/ou via un capteur d'accélération longitudinale (14), dans lequel est utilisée, en tant que grandeur de modification de dynamique de roulage, une modification réelle de vitesse (dwIst1, dwIst2) ou une accélération réelle de véhicule (aIst1, aIst2) et celles-ci peuvent être comparées à une valeur attendue (aTest, dwSoll), dans lequel la valeur attendue est l'accélération réelle de véhicule (aTest) établie et/ou une modification de consigne de vitesse (dwSoll) des roues (6a, 6b) qui en découle.

**20.** Procédé selon la revendication 19, **caractérisé en ce qu'**une grandeur de modification de dynamique de roulage (aIst1, aIst2, dwIst1, dwIst2) déterminée via le capteur de vitesse (13a, 13b) est comparée à une grandeur de modification de dynamique de roulage (aIst1, aIst2, dwIst1, dwIst2) saisie via le capteur d'accélération longitudinale (14) pour rendre plausible la grandeur de modification de dynamique de roulage (aIst1, aIst2, dwIst1, dwIst2) déterminée.

**21.** Procédé selon l'une des revendications précédentes, **caractérisé en ce que** les paramètres de commutation (tE, tA, P) sont acquis pour une valve d'admission (9a, 9b) formée en tant que valve de commande magnétique et/ou une valve d'échappement (10a, 10b) formée en tant que valve de commande magnétique, dans lequel

- la valve d'admission (9a, 9b) passe, suite à une activation pendant une commande avec un nombre (C1, C2) d'impulsions de commande (A), dans sa position ouverte dans laquelle une modification de la dynamique de roulage (w, w1, w2) peut être opérée par une augmentation de la pression de freinage (pBa, pBb) lorsque la valve d'échappement (10a, 10b) est simultanément passée dans sa position fermée, et
- la valve d'échappement (10a, 10b) passe, suite à une désactivation pendant une non-commande avec un nombre (C1, C2) d'impulsions de non-commande (NA), dans sa position ouverte dans laquelle une modification de la dynamique de roulage (w, w1, w2) peut être opérée par une réduction de la pression de freinage (pBa, pBb) lorsque la valve d'admission (9a, 9b) est simultanément passée dans sa position fermée.

**22.** Système de freinage (1), en particulier système de freinage (1) électropneumatique, pour un véhicule (3), en particulier un véhicule utilitaire, approprié pour la mise en œuvre du procédé selon l'une des revendications précédentes, avec des freins de service (5a, 5b), des modulateurs (8a, 8b) montés en amont des freins de service (5a, 5b) pour moduler une pression de freinage (pBa, pBb) au niveau des cylindres de frein (4a, 4b) des freins de service (5a, 5b) par commande électrique de valves de commande magnétique (9a, 9b, 10a, 10b) dans les modulateurs (8a, 8b) respectifs via des signaux de commande (Sa, Sb), dans lequel les signaux de commande (Sa, Sb) sont donnés par un dispositif de commande (7), dans lequel le dispositif de commande (7) est conçu pour déterminer au moins deux trains d'impulsions de test (PF1, PF2) pour la mise en œuvre d'au moins deux freinages de test et les moduler au niveau des valves de commande magnétique (9a, 9b, 10a, 10b), ainsi qu'en fonction d'une modification de la dynamique de roulage (w1, w2) suite aux freinages de test pour déterminer et acquérir des paramètres de commutation (tE, tA, P) des valves de commande magnétique (9a, 9b, 10a, 10b).

**23.** Système de freinage (1) selon la revendication 22, **caractérisé en ce que** le dispositif de commande (7) est conçu pour commander les valves de commande magnétique (9a, 9b, 10a, 10b) individuellement par rapport à une roue ou individuellement par rapport à un axe ou individuellement par rapport à un côté.

**24.** Système de freinage (1) selon la revendication 22 ou 23, **caractérisé en ce que** le dispositif de commande (7) est conçu pour déterminer les paramètres de commutation (tE, tA, P) sans recours à un capteur de pression.

**25.** Système de freinage (1) selon l'une des revendications 22 à 24, **caractérisé en ce que** les valves de commande magnétique sont réalisées dans le modulateur (8a, 8b) en tant que valves d'admission (9a, 9b) pour l'augmentation de la pression de freinage (pBa, pBb) au niveau du frein de service (5a, 5b) respectif et en tant que valves d'échappement (10a, 10b) pour la réduction de la pression de freinage (pBa, pBb) au niveau du frein de service (5a, 5b) respectif,
dans lequel les valves d'admission (9a, 9b) passent, suite à une commande avec une impulsion de commande (A), dans leur position ouverte pour l'augmentation de la pression de freinage (pBa, pBb) avec une valve d'échappement (10a, 10b) simultanément fermée, et les valves d'échappement (10a, 10b) passent, suite à une non-commande avec une impulsion de non-commande (NA), dans leur position ouverte pour la réduction de la pression de freinage (pBa, pBb) avec une valve d'admission (9a, 9b) simultanément fermée.

Fig. 1

Fig. 2a

Fig. 2b

**Fig. 3a**

**Fig. 3b**

tEffOnTest / 3

tEffOnTest / 3

tEffOnTest / 3

P0

P0

P0

A

A

A

t

tOn1

tOn1

tOn1

PF1 (C1 = 3)

tEffOnTest / 7

P0

P0

A

A

A

A

A

A

A

tOn2

PF2 (C2 = 7)

**Fig. 4**

Fig. 5

St1 — aTest

St2 — tEffOnTest / tEffOffTest

St3 — tOn1 / tOff1

St31 — tOn2 / tOff2

St4 — PF1 (C1)

St41 — PF2 (C2)

St5 — aIst1 / dwIst1

St51 — aIst2 / dwIst2

St6 — tEffOnIst1, tEffOnIst2 / tEffOffIst1, tEffOffIst2 / B (aTest, dwSoll) / E / P, P0, PIst

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102014006614 A1
- JP S62173366 A
- DE 19510933 A1
- DE 102011111862 A1
- EP 1142768 A2
- WO 0192075 A1